(19) Europäisches Patentamt
European Patent Office
Office européen des brevets

(11) **EP 1 827 693 B1**

(12) **EUROPEAN PATENT SPECIFICATION**

(45) Date of publication and mention
of the grant of the patent:
**24.03.2010 Bulletin 2010/12**

(21) Application number: **05812875.2**

(22) Date of filing: **07.12.2005**

(51) Int Cl.:
***B01L 3/00*** *(2006.01)*

(86) International application number:
**PCT/DK2005/050009**

(87) International publication number:
**WO 2006/061026 (15.06.2006 Gazette 2006/24)**

(54) **A MICRO FLUIDIC DEVICE AND METHODS FOR PRODUCING A MICRO FLUIDIC DEVICE**

MIKROFLUIDVORRICHTUNG UND VERFAHREN ZUR HERSTELLUNG EINER MIKROFLUIDVORRICHTUNG

DISPOSITIF MICROFLUIDIQUE ET PROCEDES PERMETTANT DE PRODUIRE CE DISPOSITIF MICROFLUIDIQUE

(84) Designated Contracting States:
**AT BE BG CH CY CZ DE DK EE ES FI FR GB GR HU IE IS IT LI LT LU LV MC NL PL PT RO SE SI SK TR**

(30) Priority: **09.12.2004 DK 200401913**
**09.12.2004 US 634289 P**
**12.01.2005 DK 200500057**
**12.01.2005 US 642987 P**

(43) Date of publication of application:
**05.09.2007 Bulletin 2007/36**

(73) Proprietor: **Scandinavian Micro Biodevices ApS**
**3520 Farum (DK)**

(72) Inventors:
• **BAU-MADSEN, Niels Kristian**
**DK-2900 Hellerup (DK)**
• **BARHOLM-HANSEN, Claus**
**DK-3500 Værløse (DK)**
• **JONSMANN, Jacques**
**DK-3330 Gørløse (DK)**
• **OVERBY, Bent**
**DK-2600 Glostrup (DK)**

(74) Representative: **Hegner, Anette et al**
**Hegner & Partners A/S**
**Banemarksvej 50**
**2605 Brøndby (DK)**

(56) References cited:
**GB-A- 2 341 924     US-A1- 2002 003 001**

**Description**

TECHNICAL FIELD

The invention relates to a micro fluidic device comprising at least one flow channel.

BACKGROUND ART

Micro fluidic devices comprising one or more flow channels are well known in the art. Such devices normally depend totally or partly on capillary forces to fill the channels. The geometry of the channels is therefore very important as it is the detailed shape of the liquid front at the liquid/air/solid interface that determines the magnitude of the capillary forces. Smaller geometries generally exhibit greater capillary pull than larger geometries. Therefore any small slit or gap in liquid connection with the flow channel becomes of interest.

A micro fluidic device is normally produced from a cartridge base comprising a channel in the form of a channel shaped depression and a lid, the two parts being fixed to each other to form the micro fluidic device. Of course each of the two parts, the cartridge base and the lid, may be provided by two or more parts, and also the lid may comprise one or more depressions. However, in the present application the term cartridge base is used to designate the part with the deepest depression, and the part covering this depression is designated the lid.

In general, it is desired to have high control of a liquid flow in a flow channel, and in particular it is important that creations of unintended air pockets, non-wetted surface sections and similar are avoided. The inventors of the present invention have made the observance that effects at the interface between the cartridge base and the lid appear to be a main cause for the absence of the desired flow control.

When bonding such cartridge base and such lid to each other e.g. using glue, mechanical fixing, adhesives, solvent assisted joining or welding, two different approaches have been attempted. In one approach the bonded area lies beyond the edge of the channel, leaving a tiny gap between lid and cartridge base. This method leaves a tiny gap often of varying size along the channel. Such small gap will fill much more quickly than the flow channel due to a stronger capillary action, and thereby the filling action in such a gap may proceed ahead of the flow in the center of the flow channel, whereby the flow may result in the formation of undesired air-pockets or air-bubbles which may result in an increased, undesired variability in the filling time for otherwise comparable components.

In another approach the bonded area extends over the channel edge in a random fashion resulting in bonding material entering or deforming the channel. As such sealing material normally will be less hydrophilic than the flow channel surface, such undesired bonding material may further result in undesired and random regulations of the liquid flow in the channel. This approach is thus very sensitive to even very small variations of the cartridge base and the lid as these will lead to different amounts of molten material in the channels. The requirement to low process tolerances will thus be undesired high to reduce this effect.

SUMMARY OF INVENTION

The objective of the invention is to provide a micro fluidic device which does not have the drawbacks as described above.

The objective of the invention is thus in particular to provide a micro fluidic device wherein undesired effects at the interface between the cartridge base and the lid are reduced, whereby an improved control of the flow in the flow channel can be obtained.

A further objective of the invention is to provide a method of producing a micro fluidic device with a channel, which is simple and have high reproducibility in relation to obtaining micro fluidic devices with desired filling properties.

A further objective of the invention is to provide a method of producing a micro fluidic device that may easily be produced allowing for desired variability of the individual parts prior to assembly and also with respect to the variability of the joining method.

These and other objectives have been achieved by the invention as it is defined in the claims.

The micro fluidic device of the invention comprises a flow channel with an interface between a cartridge base and a lid. The cartridge base comprises a channel shaped depression and the lid is bonded to said cartridge base to form the flow channel. The interface between the cartridge base and the lid, adjacent to and along the flow channel, comprises at least two capillary gap sections in the form of a gap between the lid and the cartridge base, separated by a flow break section, which flow break section has a surface which is less hydrophilic than the surface of the cartridge base and lid in the capillary gap sections and provides a barrier for a capillary flow of liquid along adjoining capillary gap sections.

The inventors of the present invention have thus provided a micro fluidic device which provides an increased control of the capillary flow within its flow channel. The micro fluidic device of the invention thus uses the effects at the interface between the cartridge base and the lid to increase control of the flow. By varying sizes, numbers and distances of the capillary gap sections and flow break sections it will be possible to produce micro fluidic devices according to the invention with different capillary flow characteristics, and thus a specific flow characteristic for a specific use can be obtained in a relatively simple manner. Furthermore, the micro fluidic device of the invention is simple to produce and may be mass produced at acceptable costs.

In the capillary gap sections the capillary effect may thus be adjusted to a desired level, e.g. to act as a capillary pump for pulling the front of a flow through the flow channel. Since the capillary gap sections will be smaller, at least in height (distance between lid and cartridge base), the capillary effect in the capillary gap sections will be larger than in the flow channel if the surfaces thereof have corresponding surface energy.

The surface energy (also called free surface energy) is a specification of the amount of energy that is associated with forming a unit of surface at the interface between two phases. A surface will be absolutely hydrophilic i.e. having a contact angle towards water of less than 90 degree when the solid-water surface energy exceeds that of the solid-vapour interface. The bigger the difference is, the more hydrophilic the system is. In the same manner a surface can be said to be absolutely liquid-philic (liquid loving) for a certain liquid when the solid-liquid surface energy exceeds that of the solid-vapour interface. The bigger the difference is, the more liquid-philic the system is.

The surface energy and the surface tension are two terms covering the same property of a surface and in general these terms are used interchangeable. The surface energy of a surface or surface section may be measured using a tensiometer, such as a SVT 20, Spinning drop video tensiometer marketed by DataPhysics Instruments GmbH. In this application the term 'surface energy' is the macroscopic surface energy, i.e. it is directly proportional to the hydrophilic character of a surface measured by contact angle to water as disclosed below. In comparing measurements, e.g. when measuring which of two surface parts has the highest surface energy, it is not necessary to know the exact surface energy and it may be sufficient to simply compare which of the two surfaces has the lower contact angle to water.

In order to establish a capillary flow of a specific liquid in a flow channel, at least some of the surface of the flow channel wall needs to have a surface energy which can drive the liquid forward. According to a well known theory, which however should not be interpreted so as to limit the scope of the invention, a capillary flow can only be established if at least some of the surface of the flow channel wall has a contact angle to the liquid in question which is less than 90°. In principle the lower the angle is, the faster, the flow will be. In this connection it can also be mentioned that the surrounding air also may influence the contact angle between the liquid and the flow channel wall according to Youngs equation which links the contact angle, the liquid-vapour surface tension of the drop, and the surface tension of solid in contact with liquid.

Contact angle measurement is used as an objective and simple method to measure the comparative surface tensions of solids. The Young equation states that the surface tension of a solid is directly proportional to the contact angle. The equation is:

$$g(sv) = g(lv)(cosq) + g(sl)$$

where g(sv) is the solid-vapour interfacial surface tension, g(lv) is the interfacial surface tension of the liquid-vapour interface, g(sl) is the interfacial surface tension between solid and liquid, and (q) is the contact angle.

The flow break sections provide barriers to the flow i.e. the capillary effect in the capillary gap sections is larger, preferably significantly larger than the capillary effect, if any, in the flow break sections. As it will appear from the following description, the flow break section may provide a simple barrier wherein there may be a certain capillary effect, but wherein the capillary effect is less than in the capillary gap sections, or in another embodiment the flow break section may pin the flow for a certain time or it may even completely break the flow to stop further capillary flow at the interface between the lid and the cartridge base along the flow channel.

In one embodiment the flow break section is capable of pinning a liquid flow for a sufficient time to bring the flow front in the flow channel in alignment with the flow break section.

The gap distance in the capillary gap sections may be essentially equidistant along the length or it may vary e.g. along the length or in a direction perpendicular to the sectional cut perpendicular to the centre direction of the flow channel.

The centre direction is determined as the direction following a line through the flow channel which is placed as centrally in the flow channel as possible, i.e. with the largest distance to any points of the flow channel wall as possible.

As it will be clear from the following description, the micro fluidic device of the present invention opens up for a whole new way of designing micro fluidic devices and for using the interface between the cartridge base and the lid to obtain a desired capillary flow within the flow channel.

It should be observed that the cartridge base as well as the lid may be in two or more parts. The cartridge base could e.g. be produced by a first plate like unit onto which a structure is fixed to form the depression. Other combinations will be clear to the skilled person. In general it is most simple to produce each of the cartridge base and the lid in induvidual parts.

The lid may also comprise a depression, e.g. for forming a secondary flow channel (in which case it is a cartridge base concerning this secondary flow channel) or for lying coincidently with the depression in the cartridge base. For a given flow channel the one or the parts comprising the deepest depression are designated the cartridge base and the other one is designated the lid. If the parts are identical, one of them is designated the cartridge base and the other one is designated the lid.

In most situations the lid is selected to be a plane plate (also called a planar component), as this provides the cheapest solution. Such a lid plate or a lid foil may thus be produced by simple extrusion, pressing or similar techniques, where after it may be cut in desired sizes. Alternative it could be injection moulded e.g. using a multi-cavity tool.

The micro fluidic device could also comprise a plurality (3 or more) of layered units, each representing a cartridge base or a lid. Thereby a multi layered micro fluidic device can be obtained. The various fluidic layers may be completely or partly connected.

The micro fluidic device may comprise one or more openings to the flow channel, e.g. from the top, the bottom and/or one or more of the sides, such as it is generally known in the art.

Thus, in one embodiment the micro fluidic device comprises one or more openings for inlets and outlets at the ends of the channel and/or along the channel. This or these openings may face any directions, such as upwards, sideways or downwards, such as it is generally known in the art. The openings may be equipped with a removable closure, so that the one or more openings can be opened and closed as desired.

The flow channel may in principle be as long as desired, e.g. up to several meters. In most situations, however, the flow channel is less than 1 m, such as between 20 mm and 1 m. In order to have a capillary flow the flow channel should preferably be at least 5 mm, such as at least 10 mm. Most typical the flow channel will have a length between 25 and 200 mm.

In one embodiment the flow channel comprises two or more flow channel sections which differ from each other in width and/or height and/or cross sectional area in a sectional plan perpendicular to the centre direction of the flow channel sections.

In one embodiment the micro fluidic device comprises one or more chambers in the form of channel sections having more than 50 % larger cross sectional area in a sectional cut perpendicular to the centre direction of the flow channel, said chambers may e.g. be arranged to be used as reservoir chambers, mixing chambers, reaction chambers, incubation chambers, and termination chambers.

Such chambers may have any size and shape as it is well known in the art, e.g. as disclosed in US 5300779 and US 5144139.

In one embodiment the micro fluidic device has 2, 3, 4 or even further chambers of equal or different size.

The chambers may e.g. be provided with another surface characteristic than the flow channel sections connecting them. In one embodiment the lid comprises an opening at the border between a chamber and a flow section to provide a capillary stop. When the opening is closed, the capillary force at the entrance to/exit from the flow channel section is reestablished.

In one embodiment the chambers are in the form of flow channel sections comprising more than 60 % larger, such as 100 % larger, such as 200 % larger cross sectional area in a sectional plan perpendicular to the centre direction of the flow channel.

The flow channel may in principle have any dimensions as long as at least one dimension is sufficiently small to provide the capillary forces e.g. with respect to water within the flow channel.

In one embodiment of the micro fluidic device, the flow channel has a sectional width defined as the maximal width parallel to a line between the first and second edges of the depression in the cartridge base, in a sectional cut perpendicular to the centre direction of the flow channel, the sectional width preferably being at least 5 $\mu$m, such as between 10 $\mu$m, and 20 mm, such as between 20 $\mu$m and 10 mm.

The sectional width is in one embodiment essentially constant along the length of the flow channel. In another embodiment the sectional width varies along the length of the flow channel.

In one embodiment of the micro fluidic device, the flow channel has a sectional depth defined as the maximal depth perpendicular to the sectional width in a sectional cut perpendicular to the centre direction of the flow channel, the sectional depth preferably being at least 0.5 $\mu$m, such as between 1 $\mu$m and 1 mm, such as between 5 $\mu$m and 400 $\mu$m, such as 25 $\mu$m and 200 $\mu$m.

The sectional depth in one embodiment is essentially constant along the length of the flow channel. In another embodiment the sectional depth varies along the length of the flow channel.

In one embodiment at least one of the dimensions cross sectional width and cross sectional depth of the flow channel in at least one sectional cut perpendicular to the centre direction of the flow channel, has a size of less than 500 $\mu$m, such as less than 400 $\mu$m, such as less than 200 $\mu$m.

In one embodiment the flow channel has a sectional cross area perpendicular to a sectional cut perpendicular to the centre direction of the flow channel. This sectional cross area may preferably be between 2 $\mu m^2$ and 20 $mm^2$, such as between 5 $\mu m^2$ and 10 $mm^2$, such as between 100 $\mu m^2$ and 1 $mm^2$, such as between 1000 $\mu m^2$ and 0.1 $mm^2$.

The micro fluidic device may comprise one flow break section, e.g. placed strategically, such as just in front of or just after a chamber, or it may comprise two or a plurality (more than two) of flow break sections. The flow break sections may be evenly distributed along the length of the interface between the cartridge base and the lid, adjacent to and along with the flow channel.

In one embodiment the interface between the cartridge base and the lid, adjacent to and along with the flow channel, comprises a plurality of capillary gap sections in the form of gaps between the lid and the cartridge base, separated by flow break sections, which flow break sections provide a barrier to a capillary flow of liquid along adjoining capillary gap sections.

In one embodiment the interface between the cartridge base and the lid, adjacent to and along with the flow channel, comprises a first interface side on a first side of the flow channel, and a second interface side on a second side of the flow channel, and the flow break sections are present on both the first and the second interface side. These flow break sections on the first and the second interface side may e.g. be arranged in pairs, i.e. one flow break section on the first interface side is in alignment with one flow break section on the second interface side. Or in other words, the flow break sections in pairs on the respective interface sides are lying in a plane provided by a sectional cut perpendicular to the centre direction of the flow channel. The sectional cut perpendicular to the centre direction of the flow channel means that the centre direction has a tangent where it crosses the sectional cut, which tangent is normal to the sectional cut.

In one embodiment the interface between the cartridge base and the lid, adjacent to and along with the flow channel, comprises a first interface side on a first side of the flow channel, and a second interface side on a second side of the flow channel. The first and said second interface side each has a length defined as the length of the borderline between said respective interface side and said flow channel. The flow break section(s) of said respective interface side may preferably have a total length (the sum of the respective length of the flow breaks) of up to about 95 %, such as up to about 50 %, such as up to about 25 %, such as between $10^{-4}$% and 10 %, such as between 0.01 and 1 % of the length of said interface side.

The number and the total and individual length of the flow break sections should preferably be kept sufficiently low to not completely block the capillary action of a liquid such as water along an interface side.

In one embodiment the number and/or the total and/or individual length of the flow break sections along the flow channel are selected so that the capillary flow may be stopped somewhere along the flow channel dependent on the viscosity and surface tension of the fluid. Thereby these properties of the fluid may be determined. By increasing or decreasing the number and/or the total and/or individual length of the flow break sections along the length of the flow channel, the micro fluidic device may be used to determine the viscosity and the surface tension of the fluid with relative high precision.

In one embodiment the interface between the cartridge base and the lid, adjacent to and along with the flow channel consists of capillary gap sections and at least one flow break section, preferably a plurality of flow break sections.

In principle the flow break sections can be as long as desired, such as up to 5 cm each. But for most situations it is desired that the flow break sections each is about 5 mm or less.

In one embodiment the flow break section(s) each has a length of up to 500 $\mu m$, such as between 1 and 300 $\mu m$, such as between 5 and 200 $\mu m$.

Too long flow break sections may result in loss of control with a liquid flow, and it may in fact lead to increased variability between same batch components. Also it may lead to a total break of the capillary flow. Too short flow break sections may result in that the delaying effect of the flow break section may be negligible.

In one embodiment the interface between the cartridge base and the lid comprises two or more flow break sections, and these flow break sections have different sizes.

In one embodiment of the micro fluidic device of the invention, the interface between the cartridge base and the lid, adjacent to and along with the flow channel, comprises a first interface side on a first side of the flow channel, and a second interface side on a second side of the flow channel. The first and the second interface side each have a length defined as the length of the borderline between said respective interface side and said flow channel (also called borderlines between the cartridge base/lid interface and the flow channel), and each of said capillary gap sections separated by said flow break sections of said respective interface side has a length (which provides the distance between two flow break sections, and) which preferably is at least as long as the longest of the flow break sections adjacent to said capillary gap section. Thereby the capillary action in the capillary gap sections may pull a fluid through or over an in the flow direction following flow break section after a certain delay by using the kinetic energy of the flowing liquid.

As indicated above the capillary gap sections may in principle have any length as long as it is sufficiently long to provide a capillary pull on a liquid, such as water.

In a preferred embodiment the capillary gap sections each have a length of at least 5 $\mu m$, such as at least 20 $\mu m$, such as at least 50 $\mu m$, such as at least 500 $\mu m$, such as up to 25 mm, such as up to 10 mm.

The length and the size of the capillary gap sections may be equal or they may differ from each other. By the term "the size of the capillary gap sections" is meant the height (distance between lid and cartridge base) and width (width perpendicular to the borderline between the cartridge base/lid interface and the flow channel).

In one embodiment of the micro fluidic device of the invention, the interface between the cartridge base and the lid comprises two or more capillary gap sections, and these two or more capillary gap sections have different heights and/or width.

In one embodiment of the micro fluidic device of the invention, the interface between the cartridge base and the lid has a width of a sufficient size to provide a pull in a liquid, such as water flowing in the flow channel. In one embodiment it is desired that the width of the capillary gap sections should be at least 0.5 $\mu$m to provide a sufficient pull. Preferably the width should be at least 1 $\mu$m, such as at least 5 $\mu$m, such as at least 50 $\mu$m, such as up to 5 mm, such as up to 1 mm, such as up to 500 $\mu$m. In one embodiment the width of the capillary gap sections is up to 5 mm, preferably between 0.5 $\mu$m and 1 mm, such as between 1 and 10 $\mu$m. The wider the capillary gap sections are, the more liquid will be consumed to fill up the capillary gap sections. Thus for use in tests where the amount of liquid is limited, the capillary gap sections should not be too wide.

The width of the capillary gap sections may be equal along the borderlines between the cartridge base/lid interface and the flow channel or it may vary. The pulling effect of a capillary gap section only slightly depends on the width, when the width is equal to or more than the twice the height of the capillary gap section. A capillary gap section of 50 $\mu$m may thus have a capillary pulling effect which is on the same level as a capillary gap section with a width of 500 mm.

The gap distance of the capillary gap sections may be essentially equidistant along the length of the individual capillary gap sections or it may vary e.g. along the length or in a direction perpendicular to the borderlines between the cartridge base/lid interface and the flow channel.

In most situations, for simple production the gap distance of all of the capillary gap sections is essentially constant along the length of the adjacent borderline between the cartridge base/lid interface and the flow channel.

In one embodiment the gap distance varies. Preferably the gap distance varies in a direction perpendicular to the adjacent borderline between the cartridge base/lid interface and the flow channel.

In many situations, namely where the flow channel has the same width along its length and where the flow channel is straight, the two borderlines between the cartridge base/lid interface and the flow channel will be essentially parallel. In other situations the two borderlines between the cartridge base/lid interface and the flow channel may have an angle to each other, which means that the flow channel is either increasing or decreasing along its length.

The gap distance of the capillary gap sections will generally be between 0.1 $\mu$m and 400 $\mu$m, such as between 4 and 80 $\mu$m, such as between 6 and 40 $\mu$m. In one embodiment the gap distance of the capillary gap sections is less than 10 $\mu$m. If the gap distance is too small, the relative distance variation will increase and there may be a risk of irregular filling, in particular in sections with a low number of flow break sections. As the gap distance will vary locally due to production tolerances, e.g. such as local suction effects occurring in injection moulded parts, a too small gap distance will be very sensitive to such effects. If the gap distance is too large, the gap distance will have capillary forces which are on the same level as the capillary forces of the flow channel, because the distance between the cartridge base and the lid in the capillary gap section will be on level with the distance between the cartridge base and the lid in the flow channel, and the extra capillary pulling effect of the capillary gap section may not be fully utilized.

In one embodiment the gap distance in a cross sectional cut perpendicular to the centre direction of the flow channel is between 0.01 % and 80%, such as between 0.1 and 10 % of the maximal dimension of the sectional cross area of the flow channel in said cross sectional cut.

The flow break sections may be provided in a number of different ways and combinations thereof. In one embodiment, the effect of having a lower surface energy in the flow break section than in the capillary gap sections is utilized. As it is well known to the skilled person, the surface energy is very important for the capillary effect in a cavity and for whether wetting of a surface takes place or not.

The surface energy of a surface is proportional to the hydrophilic level of the surface as described above.

The surface of at least one of the cartridge base and the lid in the interface between the cartridge base and the lid in the flow break sections, adjacent to and along with the flow channel, is less hydrophilic than both of the surfaces of the cartridge base and the lid in said capillary gap sections.

Thereby a liquid, such as water will be subjected to less capillary pulling effect in the flow break section than in the capillary gap sections. The flow break sections will thus function as barriers for a flow in the interface between the cartridge base and the lid, adjacent to and along with the flow channel.

In the embodiment where the flow break sections are in the form of sections of the interface between the cartridge base and the lid, adjacent to and along with the flow channel, wherein the surface areas of at least one of the cartridge base and the lid in said flow break sections are less hydrophilic than the surface areas of the cartridge base and the lid in said capillary gap sections, in the interface between the cartridge base and the lid, adjacent to and along with the flow channel will thus be delayed by the flow break sections. The less hydrophilic the surfaces of the cartridge base and the lid are, the more a liquid flow will be delayed. In certain situation a liquid flow may even be pinned for a longer time, e.g. a second or longer.

In one embodiment the surface of the cartridge base in the flow break sections, adjacent to and along with the flow channel, is less hydrophilic than the surfaces of the cartridge base in said capillary gap sections.

The term 'hydrophilic' means 'water loving', i.e. if a first surface section is less hydrophilic than another surface, this first surface is more water loving. The term 'less hydrophilic' is used interchangeably with the term 'more hydrophobic' or in other words a first surface section will be more hydrophilic than a second surface section when the contact angle between a drop of water and the first surface section is smaller than the contact angle between a drop of liquid and the second surface section. The hydrophilic character of a surface is thus an indication of how much water loving or water hating a surface is. A surface can, as mentioned above, be characterized as being absolutely hydrophilic when having a surface angle towards water which is less than 90°, and as being absolutely hydrophobic when having a surface angle towards water which is less than 90°.

Even though the micro fluidic device of the invention in some embodiments is defined with respect to its hydrophilic character of one surface part compared to its hydrophilic character of another surface part, the micro fluidic device of the invention can be used with other liquids, in particular other polar liquids, such as body fluids and aqueous solutions and dispersions. In particular the micro fluidic device of the invention can be used in combination with liquids which have a contact angle to a less hydrophilic surface part of the cartridge base and/or the lid, which is larger than the contact angle between said liquid and a more hydrophilic surface part of the cartridge base and/or the lid. In general, in use of the micro fluidic device is preferred that the 'more hydrophilic surface parts of the cartridge base and/or the lid' are in the absolute liquid-philic domain towards the liquid to be flowing in the flow channel; or in other words the contact angle between the 'more hydrophilic surface parts of the cartridge base and/or the lid' and the liquid should be less than 90°.

In one embodiment the less hydrophilic parts are provided by depositing or coating the surface with a material of another hydrophilic character or by providing the surface with a higher surface energy by increasing or decreasing its roughness.

Methods of depositing and coating are well known in the art. Also it is known that the roughness of a surface may have a large influence on the hydrophilic character of the surface. In general it can be said that within a unit area of a rough surface, the intensity of the surface energy is greater than in the corresponding area on a smooth surface of the same material. By changing the roughness of a surface section the hydrophilic character can be changed accordingly. Without being bound by this theory, it should be mentioned that according to Wenzels theory a surface with a contact angle to a liquid which is less than 90° will obtain a reduced contact angle to said liquid when roughening the surface, and a surface with a contact angle to a liquid which is higher than 90° will obtain an increased contact angle to said liquid when roughening the surface. Further information about this effect can be found in "Surface Topology and Chemical Parameters Controlling Superhydrophobicity Studied by Contact Angle Measurements" by N.E.Schlotter, published by internet and enclosed as an appendix.

In one embodiment, at least one of the cartridge base and the lid is deposited or coated or its roughness is changed in the interface between the cartridge base and the lid in the flow break sections with a material which is less hydrophilic than the surface of the cartridge base and the lid in the capillary gap sections.

In one embodiment, at least one of the cartridge base and the lid is deposited or coated or its roughness is changed in the interface between the cartridge base and the lid in the capillary gap sections and preferably the flow channel, but not the flow break sections with a material which is more hydrophilic than the surface of the cartridge base and the lid in the flow break sections.

In one embodiment, at least one of the cartridge base and the lid is deposited or coated or its roughness is changed in the interface between the cartridge base and the lid in both the flow break sections and the capillary gap sections and preferably also the flow channel with a material which is more hydrophilic than the bulk material, followed by a step where this coating or deposited layer is removed in the flow break sections.

As the bulk material of which the cartridge base and the lid is made often is relatively hydrophobic as explained further below, the hydrophilic character is obtained by an activation treatment. Often, only the cartridge base is subjected to this activation treatment, and the lid is not treated. The part of the cartridge base surface to provide the flow break sections may e.g. be masked. The lower surface energy in the flow break sections than in the capillary gap sections is then obtained by the lower energy of the surface of the cartridge base in the in the flow break sections than in the capillary gap sections.

In another embodiment or additionally to the above, the surface of the lid in the flow break sections, adjacent to and along with the flow channel, may be less hydrophilic than the surfaces of the lid in said capillary gap sections.

Table 1 shows examples of surface energy for a number of materials (solids and liquids) in air, at 20°C. As it can be seen the surface energy of water is around 73 dynes/cm. Aqueous solutions generally lay around 60-77 dynes/cm, and for many aqueous solutions the surface energy is rather close to the surface energy of pure water.

Table 1

| Surface | surface energy (dynes/cm) |
| --- | --- |
| Acetic Acid | 28 |
| Acetone | 24 |
| Benzene | 29 |
| Carbon Tetrachloride | 27 |
| Ethyl Alcohol | 24 |
| Ether | 17 |
| Glycerol | 63 |
| Hexane | 18 |
| Isopropyl Alcohol | 22 |
| Toluene | 29 |
| Water | 73 |
| NaCl in Water (Salt Solution) | 73 |
| 1.2% $MgSO_4$ in Water (Magnesium Sulfate) | 73 |
| 5.7% NaOH in Water (Sodium Hydroxide) | 76 |
| 4.1% $H_2SO_4$ in Water (Sulfuric Acid) | 72 |
| 5% Acetic Acid (Vinegar) | 60 |
| 10% Sucrose in Water (Sugar Solution) | 73 |
| 10% Methyl Alcohol in Water | 59 |
| 5% Acetone in Water | 56 |
| Mercury | 435 |
| Polytetrafluoroethylene (Teflon*) | 18 |
| Polyvinylidene Fluoride | 25 |
| Polypropylene | 29 |
| Polyethylene | 31 |
| Polystyrene | 33 |
| Amylopectin | 35 |
| Polyepichlorohydrin | 35 |
| Amylose | 37 |
| Poly Vinyl Alcohol | 37 |
| Poly Vinyl Chloride | 39 |
| Starch | 39 |
| Polysulfone | 41 |
| Polycarbonate | 42 |
| Polyethylene Terephthalate (Polyester) | 43 |
| Casein (Milk Protein) | 43 |
| Polyacrylonitrile | 44 |
| Cellulose | 44 |

(continued)

| Surface | surface energy (dynes/cm) |
|---|---|
| Poly Hexamethylene Adipamide (Nylon 6/6) | 46 |

In one embodiment both of the cartridge base and the lid in the interface between the cartridge base and the lid in the flow break sections, adjacent to and along with the flow channel, have a surface energy of less than 80, preferably less than 73, such as less than 60, such as between 20 and 50 dynes/cm.

It is preferred that both of the cartridge base and the lid in the interface between the cartridge base and the lid in the flow break sections, adjacent to and along with the flow channel, have a surface energy which is approximately the surface energy of the bulk material of which the respective cartridge base and lid is made.

The surface of at least one of the cartridge base and the lid in the interface between the cartridge base and the lid in the capillary gap sections, adjacent to and along with the flow channel, should preferably be more than the surface energy of the liquid which is intended to flow in the flow channel. In one embodiment it is thus desired that the surface of at least one of the cartridge base and the lid in the interface between the cartridge base and the lid in the capillary gap sections, adjacent to and along with the flow channel has a surface energy of more than 40 preferably of more than 73, more preferably of more than 75, such as more than 80, such as more than 85 dynes/cm.

In one embodiment of the micro fluidic device of the invention the hydrophobic/hydrophilic effect is also utilized to control the flow of a liquid in the flow channel. The flow of a liquid in the flow channel may thus also be delayed or pinned by providing one or more sections of the flow channel with a lower surface energy than other sections of the flow channel.

Thus, in one embodiment the micro fluidic device comprises at least one hydrophobic flow channel section with a surface formed by surfaces of the cartridge base and the lid, and wherein the flow channel section surface comprises at least one hydrophobic flow channel surface part, which hydrophobic flow channel surface part is less hydrophilic than a flow channel surface part in a hydrophilic flow channel section adjacent to said hydrophobic flow channel section. The hydrophobic flow channel surface part may preferably be less hydrophilic than a corresponding hydrophilic flow channel surface part in a hydrophilic flow channel section adjacent to said hydrophobic flow channel section.

"Flow channel section" as used herein means a section of the flow channel between parallel cuts perpendicular to the centre direction of the flow channel.

When the flow channel is not straight, the sectional cut perpendicular to the centre direction of the flow channel means that the centre direction has a tangent where it crosses the sectional cut, which tangent is normal to the sectional cut.

The centre direction is as mentioned above determined as the direction following a line through the flow channel which is placed as centrally in the flow channel as possible i.e. with the largest distance to any points of the flow channel wall as possible.

Corresponding surface parts of respectively a hydrophobic flow channel section and an adjacent hydrophilic flow channel section mean parts of the respective sections which are lying with equal distance to the closest borderline between the interface and the flow channel.

In one embodiment the hydrophobic flow channel surface part is adjacent to a flow break section. The flow of a liquid will then be delayed or even pinned in aligned flow break section and hydrophobic flow channel section. Thereby highly increased control of the flow through the flow channel may be obtained.

In one embodiment the hydrophobic flow channel section comprises at least one pair of hydrophobic flow channel surface parts extending from respective borderlines between the interface sides on each side of the flow channel and the flow channel and towards each other. The pair of hydrophobic flow channel surface parts may preferably constitutes at least 5 %, such as at least 20 %, such as at least 30 %, such as at least 50 % the hydrophobic flow channel section surface.

In one embodiment the hydrophobic flow channel section comprises one hydrophobic flow channel surface part, and this hydrophobic flow channel surface part preferably constitutes at least 50 %, such as at least 80 %, such as at least 90 %, such as to all of the hydrophobic flow channel section surface.

For simple production it is preferred that essentially the entire hydrophobic flow channel section surface is constituted by the hydrophobic flow channel surface part. Thereby an effective barrier may be obtained and simultaneously the hydrophobic flow channel section may be relatively short. Thereby a high barrier or pinning of a liquid, such as water in the flow channel may be obtained, and the length of the hydrophobic flow channel section may be selected so that the barrier /pinning may be overcome by the pressure of the flowing liquid after a certain desired time delay.

In one embodiment the hydrophobic flow channel section(s) has a length along the flow direction which is up to 500 $\mu$m, such as between 1 and 300 $\mu$m, such as between 5 and 200 $\mu$m, the length of the hydrophobic flow channel section(s) preferably corresponds to the length of adjacent flow break section(s).

It is preferred that the hydrophilic flow channel section(s) has a length which is longer than an in flow direction following hydrophobic flow channel section.

This will make it easier to overcome a high barrier or pinning provided by the hydrophobic flow channel section.

In one embodiment the hydrophilic flow channel section(s) has a length along the flow direction of at least 5 $\mu$m, such as at least 20 $\mu$m, such as at least 50 $\mu$m, such as at least 500 $\mu$m, the length of the hydrophilic flow channel section(s) preferably corresponds to the length of adjacent capillary gap sections.

Preferably the hydrophobic flow channel section surface is sufficiently hydrophobic to provide a flow delay of a liquid flow in the flow channel, compared to the flow velocity of the liquid in the adjacent hydrophilic flow channel section.

In another way of providing a flow break section the flow break section(s) is provided with a lower capillary effect than the capillary gap sections. Thereby a flow in the flow break section(s) will be delayed, and thus the flow break section(s) acts as barriers to a liquid flow in the interface between the cartridge base and the lid, adjacent to and along with the flow channel.

In one embodiment of the micro fluidic device of the invention, the cartridge base and the lid in the at least one flow break section have a larger distance to each other than in adjacent capillary gap sections. Preferably at least one borderline between the flow break section and the adjacent capillary gap sections is formed by a stepwise change in the distance between the cartridge base and the lid.

The stepwise change will provide an edge between the capillary gap sections and the in flow direction following flow break section. Such an edge will as it is known by the skilled person provide a further barrier to a fluid in the flow channel. The steeper the step is, the higher the barrier effect will be. For production concern the stepwise change in the distance between the cartridge base and the lid may preferably be slightly angled. This is in particularly beneficial if the cartridge base and/or lid unit is produced by injection moulding.

In one embodiment the borderline between the flow break section and adjacent capillary gap sections each has a length which is at least the width of said capillary gap section.

In one embodiment the larger distance between the cartridge base and the lid in the flow break section is provided by a flow break indent in the cartridge base and/or in the lid. The width of the flow break indent is defined as the longest of the borderlines between the flow break section and the respective adjacent capillary gap sections. The width of the flow break indent may preferably be at least the width of the widest of the respective adjacent capillary gap sections. Thereby a flowing fluid cannot make short cuts around the edge provided by the flow break indent.

The flow break indent may have any contour on the cartridge base and/or the lid interface surface in the flow break section, e.g. V or contour, U contour.

In one embodiment the larger distance between the cartridge base and the lid in the flow break section is provided by a flow break indent in the cartridge base. The flow break indent may preferably have a dept which is at least 50 %, such as at least 75 % such as at least 95 %, such as more than 100 % of the depth of the channel shaped depression adjacent to said flow break indent.

The edges to the surface of the flow channel provided by the flow break indent may also act as flow channel delay elements. In a flow channel without such flow channel delay elements and where fluid is flowing through the flow channel under the influence of the capillary forces, it can be observed that the capillary forces are higher closer to the flow channel wall than further away from the flow channel wall. Thereby the flow front will be uneven, and be in front along the channel wall compared to central parts of the flow channel. That may e.g. give rise to formation of air pockets where the dimension of the flow channel is changing e.g. due to chambers, where the flow channel is bent or with flow channel section connections. By having such capillary breaks the flow front can be controlled. By providing the flow channel with such flow channel delay elements e.g. aligned in pairs along the flow channel, the flow from of a liquid flowing through the flow channel may be controlled.

In one embodiment the flow break indent forms edges to the surface of the flow channel with edge angles (the angel of the material between the surfaces forming the edge) of less than 135°, such as less than 115°, such as between 70 and 105°, such as between 85 and 95°.

For simple production e.g. by injection moulding it is desired that the edge angles are at least 91°, such as at least 91°, as a steeper angle may be difficult to slip off the injection moulding tool.

In one embodiment of the micro fluidic device of the invention, the larger distance between the cartridge base and the lid in the flow break section is provided by a flow break indent in the cartridge base and/or in the lid, and the depth of the flow break indent is at least twice, such as at least 4 times, such as at least 6 times, such as at least 10 times the maximal distance between the cartridge base and the lid in the adjacent capillary flow sections. A preferred depth of the flow break indent is at least 0.5 $\mu$m, such as between 1 $\mu$m and 1 mm, such as between 5 $\mu$m and 400 $\mu$m, such as 25 $\mu$m and 200 $\mu$m.

As mentioned above it is desired that the stepwise change in the distance between the cartridge base and the lid to form the borderline between the flow break section and the adjacent capillary gap sections is sufficiently steep to provide provides a barrier to an advancing flow of liquid such as water.

In one embodiment the stepwise change in the distance between the cartridge base and the lid to form the borderline between the flow break section and the adjacent capillary gap sections forms at least one edge, with an edge angle (the angle of the material between the surfaces forming the edge) of less than 135°, such as less than 115°, such as between 70 and 105°, such as between 85 and 95°.

The borderlines between the flow break section and the adjacent capillary gap sections are as the term is used herein, the borderline formed by edges of respectively the cartridge base or the lid whichever comprises the flow break indent. If both the cartridge base and the lid comprise a flow break indent, the borderlines between the flow break section and the adjacent capillary gap sections are the borderline formed by edges of the cartridge base.

In one embodiment the micro fluidic device comprises at least one low capillary flow channel section with a surface formed by surfaces of the cartridge base and the lid, and wherein said flow channel section surface has less capillary effect provided by a longer distance between the cartridge base and the lid in said low capillary flow channel section of the flow channel than in other part of the flow channel. In one embodiment the larger distance between the cartridge base and the lid in the low capillary flow channel section is aligned with flow break sections in pairs provided by a flow break indent in the lid. Preferably both the low capillary flow channel section and the flow break sections are provided by an indent in the lid.

In one embodiment the flow break section(s) comprises bonding material, such as glue or solidified welding polymer originating from the molten material during the welding which has flown into flow break sections while bonding the cartridge base and the lid. Such bonding material will in most circumstances have a relatively low surface energy. The bonding material may e.g. be material of one or both of the cartridge base and the lid or it may be a glue or a combination thereof. In one embodiment the bonding material has a hydrophobic surface which is less hydrophilic than the surface of the lid and/or the cartridge base in the capillary gap sections. Thereby an additional flow break effect in the flow break section is provided.

The bonding material may even be penetrated into the flow channel, whereby hydrophobic flow channel section (s) may be provided.

In one embodiment the micro fluidic device comprises at least one hydrophobic flow channel section with a surface formed by surfaces of the cartridge base and the lid, and wherein said flow channel section surface comprises at least one hydrophobic flow channel surface part formed by bonding material which has penetrated into the flow channel, and wherein the hydrophobic flow channel surface part is less hydrophilic than a flow channel surface part in a hydrophilic flow channel section adjacent to said hydrophobic flow channel section. The hydrophobic flow channel surface part may preferably be less hydrophilic than a corresponding hydrophilic flow channel surface part in a hydrophilic flow channel section adjacent to said hydrophobic flow channel section.

Sizes and arrangement of the hydrophobic flow channel section provided by bonding material may be as the sizes and arrangements of the hydrophobic flow channel section as described above.

As it will be understood the hydrophobic flow channel section provided by bonding material, has functions on the flow in the flow channel as it is described above for the hydrophobic flow channel section in general.

In yet another way of providing a flow break section the flow break section is in the form of a complete blocking of the interface between the cartridge base and the lid, adjacent to and along with the flow channel in the flow break section.

Thereby a flow in the flow break section will be pinned. After the capillary gap section in fluid direction in front of the flow break section has been filled with liquid the liquid therein may be still, or it will be returned to the flow channel.

Therefore, in one embodiment of the micro fluidic device of the invention the cartridge base and the lid in the at least one flow break section are bonded to each other, the bonding material preferably extending beyond the border between the interface between the cartridge base and the lid and into the flow channel in said flow break sections.

As mentioned above such bonding material will normally be relatively hydrophobic, and thus it is also desired that the bonding material preferably has a hydrophobic surface which is less hydrophilic than the surface of the lid and/or the cartridge base in the capillary gap sections, whereby hydrophobic flow channel section(s) may be provided.

In one embodiment the micro fluidic device comprises at least one hydrophobic flow channel section with a surface formed by surfaces of the cartridge base and the lid, and wherein said flow channel section surface comprises at least one hydrophobic flow channel surface part formed by bonding material which has penetrated into the flow channel. The hydrophobic flow channel surface part is less hydrophilic than a flow channel surface part in a hydrophilic flow channel section adjacent to said hydrophobic flow channel section. Preferably the hydrophobic flow channel surface part is less hydrophilic than a corresponding hydrophilic flow channel surface part in a hydrophilic flow channel section adjacent to said hydrophobic flow channel section.

Sizes and arrangement of the hydrophobic flow channel section provided by bonding material may be as the sizes and arrangements of the hydrophobic flow channel section as described above.

As it will be understood the hydrophobic flow channel section provided by bonding material, has functions on the flow in the flow channel as it is described above for the hydrophobic flow channel section in general.

In one embodiment the at least one hydrophobic flow channel surface part provided by bonding material has a convex shape. In general such a convex shape requires less energy to overcome by a flowing liquid than a concave shaped hydrophobic flow channel surface part. Therefore for increasing the flow channel delay it is desired that the hydrophobic flow channel surface part has a concave shape.

The hydrophobic flow channel surface part may preferably be adjacent to a flow break section. In one embodiment the hydrophobic flow channel section comprises at least one pair of hydrophobic flow channel surface parts extending from respective borderlines between the interface sides on each side of the flow channel and the flow channel and towards each other. The pair of hydrophobic flow channel surface parts may preferably constitute at least 5 %, such as at least 20 %, such as at least 30 %, such as at least 50 % the hydrophobic flow channel section surface.

The micro fluidic device of the invention is particularly useful when seeking to improve the flow of a liquid in flow channel bends, flow channel partitions to two or more channels or in the merging of flow channels and similar.

In one embodiment the flow channel has at least one bending, which bends said borderlines between the cartridge base/lid interface and the flow channel in an inner loop bending and an outer loop bending, said one or more flow break sections being placed along the length of at least the interface between the cartridge base and the lid, adjacent to and along with said borderline in its inner loop bending or immediately prior to its inner loop bending to provide a flow through the bend flow channel wherein the liquid front of the liquid flow closer borderline in an inner loop bending will be delayed (have less average velocity) compared to the liquid front of the liquid flow closer to the ridge bend in an outer loop bending.

The invention also relates to a method of producing a micro fluidic device as described above. The method of the invention comprises the steps of providing a cartridge base with a channel shaped depression, and a lid for said depression, bonding the cartridge base and the lid to each other to form a flow channel, so that the interface between the cartridge base and the lid, adjacent to and along the flow channel comprises at least two capillary gap sections in the form of a gap between the lid and the cartridge base, separated by a flow break section, which flow break section has a surface which is less hydrophilic than the surface of the cartridge base and lid in the capillary gap sections and provides a barrier to a capillary flow of liquid along adjoining capillary gap sections.

As it has been explained above the flow break sections may be provided by various means, such as the hydrophilic/hydrophobic means, the stepwise change of cartridge base/lid means, and the blocking means as well as combinations of all the variations described above.

In general the cartridge base and lid may, independently of each other, be made from any kind of solid material. Preferred materials include the materials selected from the group consisting of glass, ceramics, metals, silicon and polymers, preferably said cartridge base and said lid being made from a polymer, more preferably an injection mouldable polymer, such as a polymer selected from the group consisting of acrylonitrile-butadiene-styrene copolymer, polycarbonate, polydimethylsiloxane (PDMS), polyethylene, polymethylmethacrylate (PMMA), polymethylpentene, polypropylene, polystyrene, polysulfone, polytetrafluoroethylene (PTFE), polyurethane, polyvinylchloride (PVC), polyvinylidine fluoride, nylon, styrene-acryl copolymers and mixtures thereof.

In certain embodiments, additives, such as carbon black, dyes, titanium dioxide, gold, e.g. electroplated gold or electrolessly plated gold, carbon particles, additional polymers, e.g. a secondary polymer or second phase polymer reactive with the primary polymer of the laminate layer, IR absorbing materials, and the like, may be included, as a surface coating and/or a body filler, in the materials used to form any of the layers of a multi-layer laminated cartridge base and lid. A layer formed of materials suitable for micromachining may be used, for example, with another layer formed of material compatible with waveguide, thick film, thin film or other surface treatments. Given the benefit of this disclosure, it will be within the ability of those skilled in the art to select materials for the cartridge base and lid suited to the particular application.

Preferably the material used for forming the cartridge base and lid is a material which can be shaped by injection molding. Such material is normally also relatively simple to bond to other materials e.g. by welding.

The cartridge base and said lid may be bonded using any bonding method. Preferred bonding methods include the bonding methods selected from the group consisting of adhesives, mechanical sealing, solvent assisted joining, gluing and welding, such as ultrasonic welding, impulse welding, laser mask welding and heat welding.

When performing the bonding e.g. by gluing or welding, the cartridge base and the lid are pressed against each other. For controlling the bonding step to provide a desired thickness of the bonding material and/or the the interface between the cartridge base and the lid, adjacent to and along with the flow channel, a bonding stop unit in the form of a solid projection from the cartridge base and/or the lid e.g. in an area where no bonding should be provided, may be used to control the distance.

In one method of bonding using welding e.g. ultrasonic welding one of the cartridge base and the lid is provided with a projecting welding unit of the bonding material, which e.g. may be of the same material as the cartridge base/lid unit itself, When the cartridge base and the lid are pressed together during the welding process, the projecting welding unit of the bonding material is melted and binds the cartridge base and the lid together. By this process the bonding of the cartridge base and the lid can be controlled. The projecting welding unit may have any shape e.g. as an elongated mountain which is to form a bonding line.

The lid may in one embodiment also be provided with a depression, such as channel shaped depression.

In one embodiment the method includes a step of providing a plurality of cartridge bases and/or lids and bonding said plurality of cartridge base and/or lids to each other to form flow channels, thereby a multilayered micro fluidic device may be produced.

In one embodiment the method comprises the step of providing at least one of the cartridge bases and lids with an opening or a depression leading to an edge of the cartridge base/lid, to thereby form a flow channel opening. As it should be clear to the skilled person the, or these openings may be provided, simultaneously with the production of the cartridge base and lid, after these elements are provided before or after the bonding thereof. Methods of providing such openings are well known to the skilled person.

In one embodiment a method of the invention the method comprises the steps of

i. providing at least one cartridge base with a channel shaped depression,
ii. providing at least one lid for said depression;
iii. treating the cartridge base and the lid to form at least one hydrophobic surface part which is more hydrophobic than another surface part of said cartridge base and the lid; and
iv. bonding the cartridge base and the lid to each other to form a flow channel, comprising at least one hydrophobic flow channel section with a surface formed by surfaces of the cartridge base and the lid, said at least one hydrophobic surface part forms a hydrophobic flow channel surface part of said hydrophobic flow channel section surface, so that said hydrophobic flow channel surface part is less hydrophilic than a flow channel surface part in a hydrophilic flow channel section adjacent to said hydrophobic flow channel section.

The shapes of the flow break sections, capillary gap sections, flow channel and other element of the micro fluidic device may be as disclosed above.

The treating step preferably comprises an activation treatment of at least one of the cartridge base and the lid to increase its surface energy. A large number of different methods of activating a surface are well known in the art. Preferred methods for the present invention include activation by plasma treatment, such as disclosed in EP 831 679 or WO 00/44207 or corona treatment and/or by changing the surface roughness as described above.

In one embodiment the treating step comprises an activation treatment of at least one of the cartridge base and the lid to increase its surface energy, the at least one hydrophobic surface part being masked.

The masking may e.g. be performed by applying a layer of a material which afterwards can be removed without damaging the surface, e.g. be removed using a laser. Thereby will produced a cartridge base and/or lid with a lower surface energy in the at least one hydrophobic surface part, and thereby the at least one hydrophobic surface part will be more hydrophobic than the activation treated surface.

In one embodiment of the method of the invention the treating step comprises an activation treatment of at least one of the cartridge base and the lid to increase its surface energy, followed by laser treating the at least one hydrophobic surface part, to thereby remove or melt a surface layer including the activating treated surface layer at the at least one hydrophobic surface part, and thereby the at least one hydrophobic surface part will be more hydrophobic than the surrounding activation treated surface.

The laser used for performing the laser surface treatment can in principle be any kind of laser which is emitting a laser beam including a wavelength which is at least partly absorbable by the surface layer.

The laser used for removing the hydrophilic surface layer from the at least one hydrophobic surface part may in principle be any type of laser which is capable of providing a local heating of the material of the surface to thereby remove e.g. evaporate the thin hydrophilic layer, without simultaneously damaging the treated cartridge base or lid. For polymers, ordinary writing lasers which are normally used for engraving may be used. For glass and ceramics $CO_2$ lasers and CO lasers, such as the lasers disclosed in US 2002/0175151 may be used. It has thus been found that it is possible by laser equipment to remove a very thin layer of the surface which is to be a hydrophobic surface part to thereby remove the hydrophilic layer obtained in there by the activation treatment. In one embodiment the laser used is an UV excimer laser.

In one embodiment of the method of the invention, the treating step comprises an activation treatment of at least one of the cartridge base and the lid to increase its surface energy, applying a layer of material with a lower surface energy onto the activation treated surface, laser treating the activation treated surface surrounding the at least one hydrophobic surface part, to thereby remove the layer of material with a lower surface energy from the surface surrounding the at least one hydrophobic surface part, and thereby the at least one hydrophobic surface part will be more hydrophobic than the surrounding activation treated surface. The laser used here may be as above.

The activation treatment preferably includes activating treatment of the surface of at least one channel shaped depression, more preferably the channel shaped depression of the cartridge base, thereby a flow channel with a high capillary effect may be obtained.

The cartridge base and said lid may preferably be bonded in at least a first and a second bonding line extending respectively on a first and a second side of the channel shaped depression, so that the at least one hydrophobic surface part is adjacent to at least one of the bonding lines, said at least one hydrophobic surface part preferably extending from at least one bonding line to at least the closest edge of the channel shaped depression. Thereby a leak proof flow channel may be obtained, and liquid flowing in the interface between the cartridge base and the lid, adjacent to and along with the flow channel cannot short-circuit the flow break sections.

In one embodiment of producing a micro fluidic device of the invention, the method comprises the steps of

> i. providing a cartridge base with a channel shaped depression and a lid for said depression, the cartridge base being provided with at least one flow break indent adjacent to the channel shaped depression and/or the lid being provided with a flow break indent adjacent to the part of the lid to lie above the channel shaped depression, and
> ii. bonding the cartridge base and the lid to each other along to form a flow channel.

As mentioned the cartridge base and the lid may preferably be made by injection moulding. As it is well known to the skilled person the angles around edges should preferably be relatively high as disclosed above to enable the produced cartridge base/lid unit to slip of the injection moulding tool. Otherwise the dimensions of the cartridge base, lid and the whole micro fluidic device may be as disclosed above.

In one embodiment the cartridge base and the lid are bonded in at least a first and a second bonding line extending respectively on a first and a second side of the channel shaped depression.

Preferably the cartridge base and the lid are bonded so that the flow break indent is adjacent to or extending into the bonding. This method is very simple and easy to reproduce.

In one embodiment the cartridge base and said lid are bonded so that bonding material, such as glue or welding polymer flows into a flow break section provided by the gap between the cartridge base and the lid at the flow break indent. The amount of glue or the welding process may be controlled so that more or less of the molten material during the bonding process is flowing into the flow break indent, or even further into the flow channel.

In one method of producing a micro fluidic device or the invention, the method comprises the steps of

> i. providing a cartridge base with a channel shaped depression,
> ii. providing a lid for said depression;
> iii. bonding the cartridge base and the lid to each other to form a flow channel,

said bonding step includes bonding the cartridge base and the lid to each other in at least a first and a second bonding line extending respectively on a first and a second side of the channel shaped depression so that the interface between the cartridge base and the lid, adjacent to and along with the flow channel, comprises at least two capillary gap sections in the form of a gap between the lid and the cartridge base, separated by a flow break section, and the bonding material extends beyond the border between the interface of the cartridge base and the lid and into the flow channel in at least one flow break section.

As it will be evident to the skilled person, the invention may be carried out in other ways and combinations, while still using the core of the invention.

As an example it should be mentioned that in one embodiment, a micro fluidic device according to the invention, such as a micro fluidic device comprising one or more flow break sections, may comprise energy barriers such as ribs extending across a portion of the channel between two opposite walls of the channels such as described in US 4618476 which is hereby incorporated by reference. The energy barriers, including sizes, shape and configuration of the energy barriers, may be as described in US 4618476.

In one embodiment of a micro fluidic device according to the invention such as a micro fluidic device comprising one or more flow break sections, the flow channel may comprise a plurality of microstructures, such as described in US 6451264. The microstructures may preferably be placed in a curved portion of the flow channel. The microstructures including its sizes, shape and configuration may be as disclosed in US 6451264. The combination of having both flow break sections along the borderlines between the cartridge base/lid interface and the flow channel and microstructures in the flow channel in a curved portion of the flow channel may result in a highly increased control of a flow through the micro fluidic device.

In use the micro fluidic device of the invention should preferably be selected dependant on the surface tension of the liquid which should flow in the flow channel by capillary forces. As mentioned above, a capillary flow of a specific liquid in a flow channel can only be established if at least some of the surface of the flow channel wall has a contact angle to the liquid in question which is less than 90°. This is well known to the skilled person.

## BRIEF DESCRIPTION OF DRAWINGS

Examples of embodiments of the invention will be described below with references to the drawings:

FIG. 1 shows a sectional top view of a section of a first micro fluidic device, according to the invention.

FIG. 2 is a perspective view of a section of a cartridge base which can be used in the production of a micro fluidic device according to the invention.

FIG. 3a is a top view of a section of another cartridge base which can be used in the production of a micro fluidic device according to the invention.

FIG. 3b is a sectional top view of a section of a micro fluidic device comprising the cartridge base shown in FIG. 3a.

FIG. 4a is a sectional side view in the cut line A-A' of the cartridge base shown in FIG. 3a.

FIG. 4b is a sectional side view in the cut line B-B' of the micro fluidic device shown in FIG. 3b.

FIG. 5a shows a sectional top view of a section of a second micro fluidic device according to the invention.

FIG. 5b is a sectional side view in the cut line B-B' of the micro fluidic device in FIG. 5a.

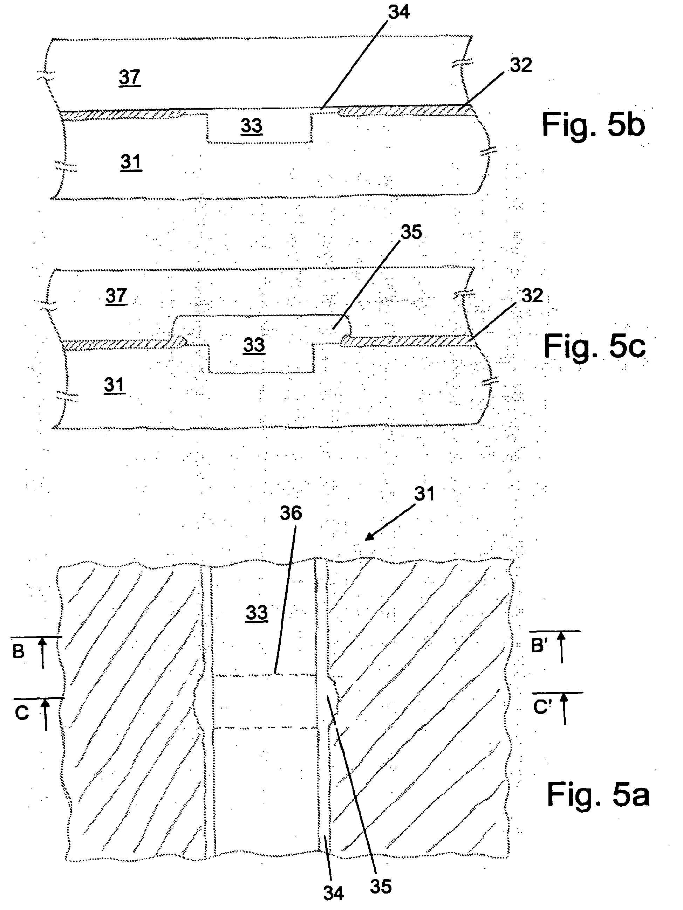

FIG. 5b is a sectional side view in the cut line C-C' of the micro fluidic device in FIG. 5a.

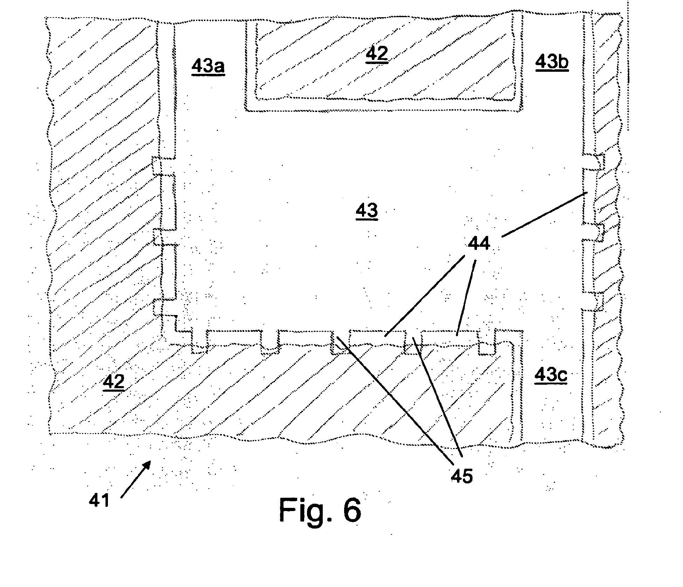

FIG. 6 shows a sectional top view of a section of a third micro fluidic device, according to the invention.

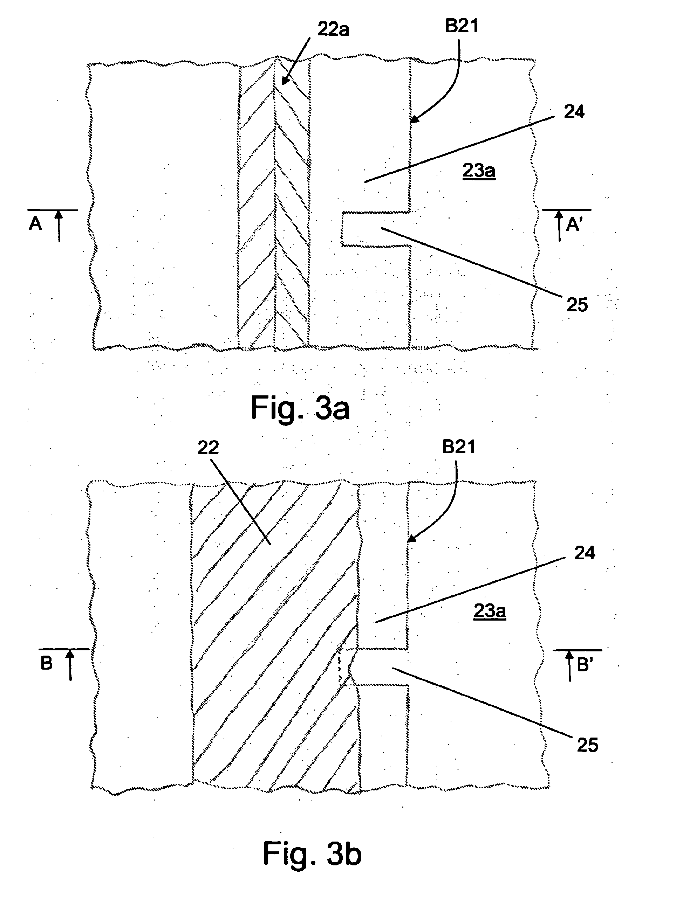

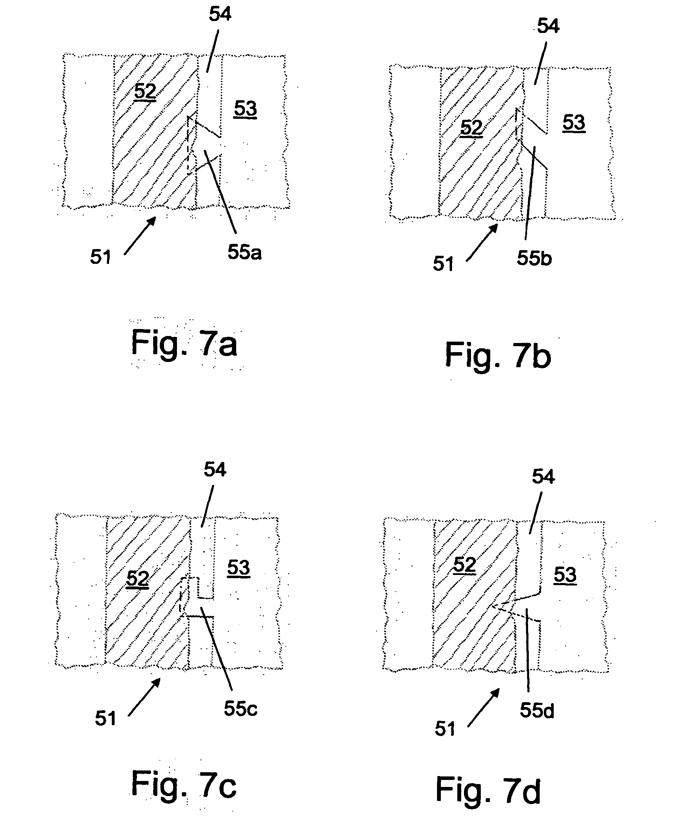

FIGs. 7a-7d are sectional top views of sections of micro fluidic devices similar to the micro fluidic device shown in FIG. 3b, but with other geometries of the indents.

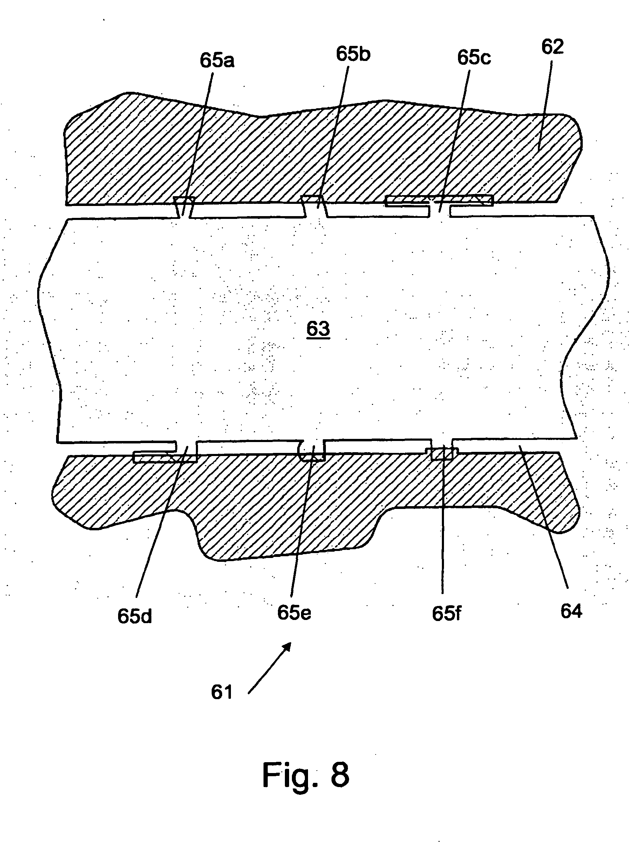

FIG. 8 is a sectional top view of a section of a micro fluidic device similar to the micro fluidic device shown in FIG. 3b, but with different geometries of the indents.

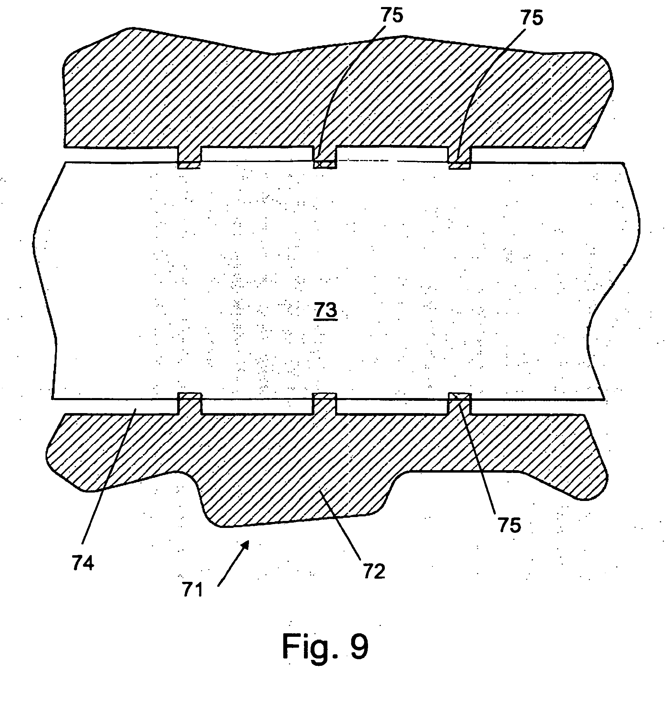

FIG. 9 is a sectional top view of a section of a fourth micro fluidic device of the invention.

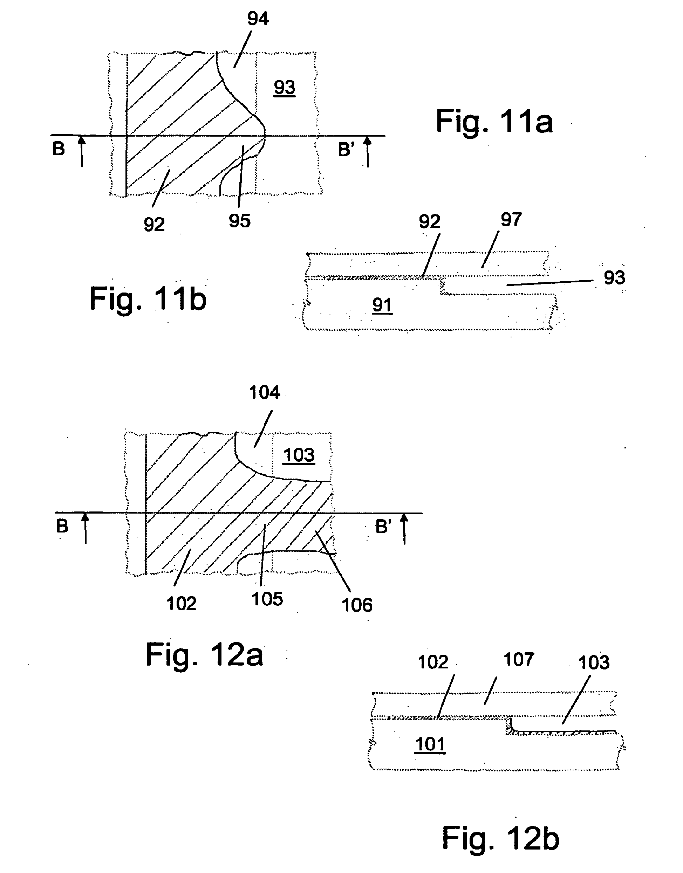

FIG. 11 a and 11 b are respectively, a sectional top view and a sectional side view of a section of a micro fluidic device similar to the micro fluidic device shown in FIG. 9, but with other geometries of the bonding material.

FIG. 12a and 12b are respectively, a sectional top view and a sectional side view of a section of a micro fluidic device similar to the micro fluidic device shown in FIG. 9, but with other geometries of the bonding material.

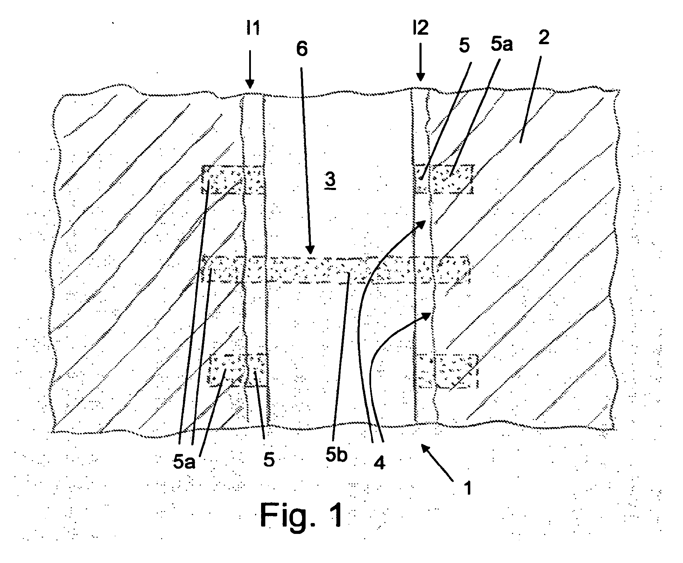

In the embodiment of a micro fluidic device according to the invention shown in FIG. 1 only a section of the micro fluidic device is shown. The top cut is taken in the bonding line, which means that the figure shows the cartridge base 1 with a layer of the bonding material 2. The micro fluidic device comprises a flow channel 3. The cartridge base 1 is bonded to a not shown lid by the bonding material 2. The interface between the cartridge base 1 and the not shown lid, adjacent to and along with the flow channel 3, comprises a number of capillary gap sections 4 in the form of a gap between the lid and the cartridge base, separated by a flow break sections 5.

The surface of the cartridge base in the interface between the cartridge base and the lid in the flow break sections 5, adjacent to and along with the flow channel 3, is less hydrophilic than both of the surfaces of the cartridge base and the lid in the capillary gap sections. This is indicated by the dotted area. As it can be seen the less hydrophilic dotted area extends beyond the bonding material 2 in the section 5a. By providing the less hydrophilic dotted area to extend to a sufficient distance from the borderline between the cartridge base/lid interface and the flow channel away from the flow channel, it will be simple to produce the micro fluidic device so that the whole surface of the cartridge base in the flow break section is less hydrophilic even when taken production tolerances into consideration. Thereby a high quality can be obtained in a very simple manner.

As it can be seen the flow break sections 5 are arranged in pairs, i.e. one flow break section 5 on a first interface side I1 is in alignment with one flow break section 5 on the second interface side I2.

One of the pairs of flow break sections is aligned with each other in a hydrophobic flow channel section 6. The hydrophobic flow channel section 6 comprises at least one hydrophobic flow channel surface part 5b, which in the shown embodiment is constituted by the whole of the surface of the cartridge base 1, in the hydrophobic flow channel section 6.The hydrophobic flow channel surface part 5b is less hydrophilic than a corresponding hydrophilic flow channel surface part in a hydrophilic flow channel section adjacent to said hydrophobic flow channel section. The hydrophobic flow channel section 6 provides a delaying section which will delay the front of a liquid flowing through the flow channel.

Thereby an additional control of the flow in the flow channel 3 may be obtained. In the shown embodiment only one hydrophobic flow channel section is seen. Of course the micro fluidic device could comprise as many of such hydrophobic flow channel sections as desired. The skilled person will be able to optimize a micro fluidic device of the invention based on the above teaching.

As explained above the less hydrophilic areas 5, 5a, 5b of the cartridge base 1, may be provided by different means, e.g. by selectively removing a thin film coating of a more hydrophilic layer which previously has been applied over the whole surface; by selectively removing a thin layer of the surface after previously having subjected the whole surface to an activation treatment e.g. using plasma activation; by deposition of material or by other how altering the surface material properties. The modification and/or the removal of a thin coating can be performed by a laser treatment e.g. using UV excimer LASER radiation.

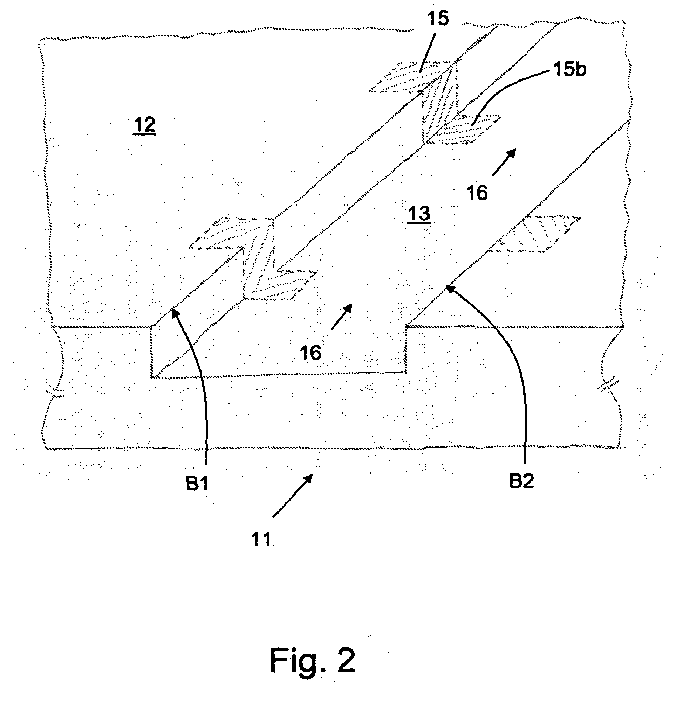

The cartridge base 11 shown in FIG. 2 comprises a channel shaped depression 13 and an upper surface 12, which is adapted to be bonded to a not shown lid, e.g. by gluing or welding. The cartridge base 11 comprises two borderlines B1 and B2 along the channel shaped depression 13. These borderlines B1, B2 are to be borderlines between the cartridge base/lid interface and the flow channel when a lid has been bonded to the cartridge base 11. The cartridge base 11 comprises surface areas 15, 15b which are less hydrophilic than the surrounding areas such as corresponding areas along the shaped depression channel 13. When a lid has been bonded onto the cartridge base 11, the less hydrophilic areas 15 will form flow break sections at the interface between the cartridge base and the lid, adjacent to and along with the flow channel formed by the channel shaped depression 13 and the lid. Between the flow break sections adjacent to and along with the flow channel capillary gap sections 16 will be formed.

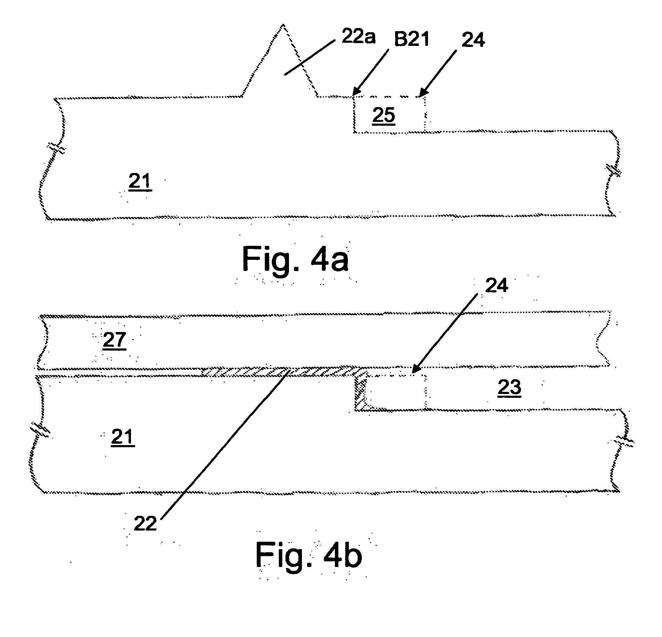

Reference is now made to FIG. 3a and FIG. 4a which show a cartridge base for a micro fluidic device, and FIG. 3b and FIG. 4b which show a micro fluidic device of the invention comprising the cartridge base of FIG. 3a and FIG. 4a.

For simplification all the figures show only sections and not complete elements. The cartridge base shown in FIG. 3a and FIG. 4a comprises a channel shaped depression 23a and two borderlines where only one is shown B21 along the channel shaped depression 23a. Along the borderline B21, the cartridge base comprises a flow break indent 25. As it can be seen on FIG 4a the flow break indent 25 is as deep as the channel shaped depression 23a. The cartridge base further comprises a projecting welding unit 22a. The projecting welding unit 22a may act as an energy director for ultrasonic bonding.

The cartridge base 21 and optionally the lid 27 may preferable be produced from polystyrene by injection moulding. The surface of the cartridge base 21 (and optionally the lid 27) may preferably be coated with a thin hydrophilic coating or be subjected to an activating treatment (e.g. plasma- or flame-treatment) at least in the parts forming the walls of the flow channel 23 to aid the capillary driven filling of the flow channel 23.

In the sectional cut of the micro fluidic device shown in FIG. 3b and FIG. 4b, the projecting welding unit 22a has been deformed during the welding process to form the bonding material 22 between the lid 27 and the cartridge base 21. As it can be seen, some of the bonding material 22 has been pressed into the flow break indent 25. In the bonding process it is desired that the process is controlled to an extent that guaranties that the edge of the bonding material after the parts have been presses together lies within the break indent. The width of the break indent defines the required tolerance.

The interface between the cartridge base 21 and the lid 27, adjacent to and along with the flow channel 23 comprises capillary gap sections 24 in the form of a gap between the lid 27 and the cartridge base 21, separated by flow break section 25 formed by the flow break indent 25. In FIG. 4a and FIG. 4b the section of the cartridge base with the surface of the interface forming a capillary gap section 24 is illustrated by a dotted line. As it has been explained above the bonding material 22 may very likely have a surface which is less hydrophilic than the remaining of the surface of the cartridge base 21 and/or the lid 27. This property may be used further for controlling the flow of a liquid in the flow channel 23.

The bonding of the cartridge base 21 and the lid 27 may preferably be performed using ultrasonic bonding. The edge between the flow break indent 25 and the capillary gap section 24 presents a barrier for a fluid moving along the gap ahead of a the bulk flow in the channel 23a. The fluid in the gap will thus stop and not proceed before the gap 25 has been reached or even surpassed by the flow in the channel 23 a

FIG. 5a shows a section of another micro fluidic device according to the invention. The top cut is taken in the bonding line, which means that the figure shows the cartridge base 31 with a layer of the bonding material 32. The micro fluidic device comprises a flow channel 33. The cartridge base 1 is bonded to a lid 37 by the bonding material 2. The lid 37 cannot be seen in FIG. 5a, but in FIG. 5b and FIG. 5c, which are sectional side cuts in respectively the cut lines B-B' and C-C'. The interface between the cartridge base 31 and the lid 37, adjacent to and along with the flow channel 33, comprises a number of capillary gap sections 34 in the form of a gap between the lid and the cartridge base, separated by flow break sections 35. The flow channel 33 comprises a low capillary flow channel section 36 indicated by the dotted line. The low capillary flow channel section is provided by a larger distance between the cartridge base 31 and the lid 37 in said low capillary flow channel section than in other sections of the flow channel 33. As it can be seen in the respective cuts shown in FIGs. 5b and 5c the larger distance between the cartridge base 31 and the lid 37 in the low capillary flow channel section 36 is aligned with flow break sections 3 in pairs and is provided by a flow break indent 38 in the lid. As it can be seen the bonding material 32, is not squeezed as much along the flow break sections 35 as along the capillary gap sections 34.

FIG. 6 shows a sectional top view of a section of a third micro fluidic device according to the invention. The micro fluidic device shown comprises a flow channel chamber 43 with 3 connecting flow channel sections 43a, 43b and 43c. At least one of them is an in flow channel and at least one of them is an out flow channel. The top cut is taken in the bonding line, which means that the figure shows the cartridge base 41 with a layer of the bonding material 42. The cartridge base 41 is bonded to a not shown lid by the bonding material 42. The interface between the cartridge base 41 and the not shown lid, adjacent to and along with the flow channel sections and chamber 43, 43a, 43b, 43c, comprises a number of capillary gap sections 44 in the form of a gap between the lid and the cartridge base, separated by a flow break sections 45. The flow break sections 45 are provided by flow break indents in the cartridge base as it has already been shown and explained in FIGs. 3a and 3b. If e.g. channel section 43a is used as in flow channel, the liquid will immediately flow along the capillary gap section 44 between channel section 43a and 43b and the liquid in the flow channel will likely be filled, with the result that the liquid will flow directly into channel section 43b without even wetting the whole of the chamber section wall. Therefore in the present embodiment the channel section 43c is to be selected as the in flow channel. As it will be understood by the skilled person, the liquid flow front will be delayed at the flow break sections 45 nearest the exit of the flow channel section 43c, and again at the next coming flow break sections 45, and the whole flow chamber section 43 will be filled up before the liquid will flow further into both of the other two flow channel sections 43a and 43b.

The figures FIGs. 7a-7d show sectional top views of sections of micro fluidic devices similar to the micro fluidic device shown in FIG. 3b, but with other geometries of the indents.

The micro fluidic devices comprises each a flow channel 53 and a bonding material 52 by which the cartridge base 51 is bonded to a not shown lid. The interface between the cartridge base 51 and the lid, adjacent to and along with the flow channel 53 comprises capillary gap sections 54 in the form of a gap between the lid and the cartridge base 51, separated by flow break section 55a, 55b, 55c, 55d formed by the flow break indent 55a, 55b, 55c, 55d. As it can be seen the flow break indent 55a, 55b, 55c, 55d may have almost any shape. The bonding material in the embodiments shown in FIGs 7a-7d is glue. When using glue the bonding edge will very likely be slightly uneven, as it is indicated in the figures.

In FIG. 8 is illustrated another variation of the micro fluidic device similar to the micro fluidic device shown in FIG. 3b, but with different geometries of the indents.

The micro fluidic device in FIG. 8 comprises a flow channel 63 and a bonding material 62 by which the cartridge base 61 is bonded to a not shown lid. The interface between the cartridge base 61 and the lid, adjacent to and along with the flow channel 63 comprises capillary gap sections 64 in the form of a gap between the lid and the cartridge base 61, separated by flow break section 65a, 65b, 65c, 65d, 65e and 65f formed by the flow break indents 65a, 65b, 65c, 65d, 65e. In this embodiment the cartridge base 61 and the lid is bonded to each other using welding. By using welding the bonding edge can be extremely precise, and the bonding line may be arranged with a high accuracy e.g. as around the indent 65f, where the bonding is extending slightly closer to the borderline to the flow channel 63, than otherwise along the borderline. The cartridge base 61 and the lid may preferably be bonded using a masking technique such as it is well known and e.g. using "MicroMaster LightDeck" equipment as market by Raymax Applications Pty Ltd, Australia.

FIG. 9 is a sectional top view of a section of a micro fluidic device of the invention, wherein the flow break sections is in the form of a complete blocking of the interface between the cartridge base and the lid, adjacent to and along with the flow channel in the flow break section provided by a bonding between the cartridge base 71 and the not shown lid.

The micro fluidic device comprises a flow channel 73 and a bonding material 72 by which the cartridge base 71 is bonded to the lid. The interface between the cartridge base 71 and the lid, adjacent to and along with the flow channel 73 comprises capillary gap sections 74 in the form of a gap between the lid and the cartridge base 71, separated by flow break sections 75 formed by bondings between the cartridge base 71 and the not shown lid. In this embodiment the cartridge base 71 and the lid is bonded to each other using welding which can be seen by the relatively accurate edge of the bonding material 72.

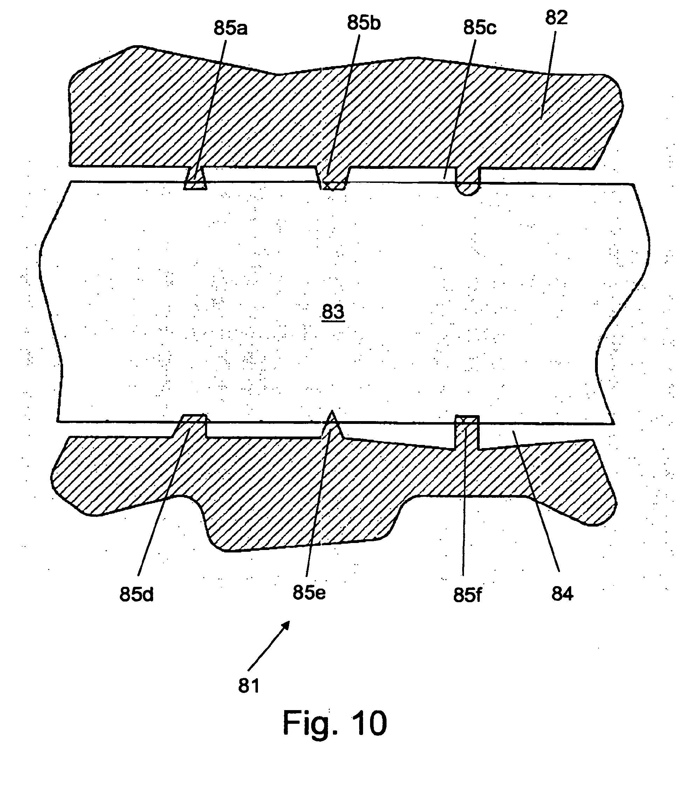

The micro fluidic device in FIG. 10 illustrates a variation of the micro fluidic device shown in FIG 9. The micro fluidic device comprises a flow channel 83 and a bonding material 82 by which the cartridge base 81 is bonded to a not shown lid. The interface between the cartridge base 81 and the lid, adjacent to and along with the flow channel 83 comprises capillary gap sections 84 in the form of a gap between the lid and the cartridge base 81, separated by flow break section 85a, 85b, 85c, 85d, 85e and 85f formed by bondings between the cartridge base 81 and the not shown lid. Also in this embodiment the cartridge base 81 and the lid is bonded to each other using welding which can be seen by the relatively accurate edge of the bonding material 82.

FIG. 11 a and 11 b are respectively, a sectional top view and a sectional side view of a section of a micro fluidic device similar to the micro fluidic device shown in FIG. 9, but in this embodiment the bonding material used is glue. FIG.

11b is a sectional side view in the sectional cut line B-B' of FIG. 11a.

The micro fluidic device comprises a flow channel 93 and a bonding material 92 by which the cartridge base 91 is bonded to the lid 97. The interface between the cartridge base 91 and the lid 97, adjacent to and along with the flow channel 93 comprises capillary gap sections 94 in the form of a gap between the lid and the cartridge base 91, separated by flow break sections 95 formed by bondings between the cartridge base 91 and the lid 97. The edge of the bonding material is rounded and is slightly uneven, which indicate that glue was used as bonding material 92.

The micro fluidic device shown in FIG. 12a and 12b is a variation of the micro fluidic device shown in FIGs 11 and 11b, in that a portion of the bonding material has been pressed into the flow channel. FIG. 12b is a sectional side view in the sectional cut line B-B' of FIG. 12a.

The micro fluidic device comprises a flow channel 103 and a bonding material 102 by which the cartridge base 101 is bonded to the lid 107. The interface between the cartridge base 101 and the lid 107, adjacent to and along with the flow channel 103 comprises capillary gap sections 104 in the form of a gap between the lid and the cartridge base 101, separated by flow break sections 105 formed by the joining of the cartridge base 101 and the lid 107. The edge of the bonding material is rounded and is slightly uneven, which indicate that glue was used as bonding material 102. A part of the bonding material 102 has penetrated into the flow channel 103 to form a hydrophobic flow channel section 106.

**Claims**

1. A micro fluidic device comprising a flow channel (3) with an interface between a cartridge base and a lid, wherein the cartridge base comprises a channel shaped depression and the lid is bonded to said cartridge base to form the flow channel, and wherein the interface between the cartridge base and the lid, adjacent to and along the flow channel comprises at least two capillary gap sections (4) in the form of a gap between the lid and the cartridge base, separated by a flow break section (5), which flow break section has a surface which is less hydrophilic than the surface of the cartridge base and lid in the capillary gap sections and provides a barrier for a capillary flow of liquid along adjoining capillary gap sections.

2. A micro fluidic device as claimed in claim 1, wherein the interface comprises a first interface side on a first side of the flow channel, and a second interface side on a second side of the flow channel, said flow break sections being present on both said first and said second interface sides.

3. A micro fluidic device as claimed in any one of the preceding claims, wherein the interface comprises a first interface side on a first side of the flow channel and a second interface side on a second side of the flow channel, said first and said second interface side each have a length defined as the length of the borderline between said respective interface side and said flow channel, and said flow break section(s) of said respective interface sides have a total length (the sum of the respective lengths of the flow break sections) of up to about 95 %, such as up to about 50 %, such as up to about 25 %, such as between $10^{-4}$% and 10 %, such as between 0.01 and 1 % of the length of said interface side.

4. A micro fluidic device as claimed in any one of the preceding claims, wherein said interface consists of capillary gap sections and at least one break section, preferably a plurality of break sections.

5. A micro fluidic device as claimed in any one of the preceding claims, wherein each flow break section has a length of up to 500 $\mu$m, such as between 1 and 300 $\mu$m, such as between 5 and 200 $\mu$m.

6. A micro fluidic device as claimed in any one of the preceding claims, wherein said interface between the cartridge base and the lid comprises two or more flow break sections and/or two or more capillary gap sections, and said flow break sections and/or said capillary gap sections have different sizes.

7. A micro fluidic device as claimed in any one of the preceding claims, wherein the interface comprises a first interface side on a first side of the flow channel, and a second interface side on a second side of the flow channel, said first and said second interface sides each have a length defined as the length of the borderline between the interface side and the flow channel, and wherein each of said capillary gap sections has a length which is as least as long as the longest of the flow break sections adjacent to said capillary gap sections.

8. A micro fluidic device as claimed in any one of the preceding claims, wherein the capillary gap sections have a length of at least 5 $\mu$m, such as at least 20 $\mu$m, such as at least 50 $\mu$m, such as at least 500 $\mu$m, such as up to 25 mm, such as up to 10 mm.

9. A micro fluidic device as claimed in any one of the preceding claims, wherein the capillary gap sections have a width perpendicular to the borderline between the interface and the flow channel, said width being at least 0.5 $\mu$m, such as at least 1 $\mu$m, such as at least 5 $\mu$m, such as at least 50 $\mu$m, such as up to 5 mm, such as up to 1 mm, such as up to 500 $\mu$m.

10. A micro fluidic device as claimed in claim 9, wherein said width varies along the length of the borderline between the interface and the flow channel.

11. A micro fluidic device as claimed in any one of the preceding claims, wherein the capillary gap sections have a gap distance, defined as the distance between the cartridge base and the lid, and perpendicular to the cartridge base, which gap distance is between 0.1 $\mu$m and 400 $\mu$m, such as between 4 and 80 $\mu$m, such as between 6 and 40 $\mu$m.

12. A micro fluidic device as claimed in any one of the preceding claims, wherein the surface of the cartridge base in the flow break sections is less hydrophilic than the surfaces of the cartridge base and the lid in the capillary gap sections, or the surface of the lid in the flow break sections is less hydrophilic than the surfaces of the cartridge base and the lid in the capillary gap sections.

13. A micro fluidic device as claimed in any one of the preceding claims, wherein the surface of at least one of, preferably both of the cartridge base and the lid in the flow break sections, has a surface energy of less than 80, preferably less than 73, such as less than 60, such as between 20 and 50 dynes/cm.

14. A micro fluidic device as claimed in any one of the preceding claims, wherein the surface of at least one of the cartridge base and the lid in the interface between the cartridge base and the lid in the capillary gap sections has a surface energy of more than 73, preferably of more than 75, such as more than 80, such as more than 85 dynes/cm.

15. A micro fluidic device as claimed in any one of the preceding claims, wherein said device comprises at least one hydrophobic flow channel section with a surface formed by surfaces of the cartridge base and the lid, and wherein said flow channel section surface comprises at least one hydrophobic flow channel surface part, which is less hydrophilic than a flow channel surface part in a hydrophilic flow channel section adjacent to said hydrophobic flow channel section.

16. A micro fluidic device as claimed in claim 15, wherein said hydrophobic flow channel surface part is adjacent to a flow break section, said hydrophobic flow channel section preferably comprises at least one pair of hydrophobic flow channel surface parts extending from respective borderlines between the interface sides on each side of the flow channel towards each other, and wherein the pair of hydrophobic flow channel surface parts preferably constitutes at least 5 %, such as at least 20 %, such as at least 30 %, such as at least 50 % of the hydrophobic flow channel section surface.

17. A micro fluidic device as claimed in claim 15, wherein said hydrophobic flow channel section comprises one hydrophobic flow channel surface part, said hydrophobic flow channel surface part preferably constitutes at least 50 %, such as at least 80 %, such as at least 90 %, such as to all of the hydrophobic flow channel section surface.

18. A micro fluidic device as claimed in any one of the claims 15-17, wherein the hydrophobic flow channel section(s) has a length along the flow direction which is up to 500 $\mu$m, such as between 1 and 300 $\mu$m, such as between 5 and 200 um, and wherein the length of the hydrophobic flow channel section(s) preferably corresponds to the length of adjacent flow break section(s)

19. A micro fluidic device as claimed in any one of the claims 15-18, wherein the hydrophilic flow channel section(s) has a length along the flow direction of at least 5 $\mu$m, such as at least 20 $\mu$m, such as at least 50 $\mu$m, such as at least 500 $\mu$m, and wherein the length of the hydrophilic flow channel section(s) preferably corresponds to the length of adjacent capillary gap sections.

20. A micro fluidic device as claimed in any one of the preceding claims 15-19, wherein the hydrophobic flow channel section surface is sufficiently hydrophobic to provide a flow delay of a liquid flow in the flow channel, compared to the flow velocity of the liquid in the adjacent hydrophilic flow channel section.

21. A micro fluidic device as claimed in any one of the preceding claims, wherein the cartridge base and the lid in the at least one flow break section has a larger distance to each other than in adjacent capillary gap sections, and wherein at least one borderline between the flow break section and the adjacent capillary gap sections is preferably formed by a stepwise change in the distance between the cartridge base and the lid.

22. A micro fluidic device as claimed in claim 21, wherein the borderline between the flow break section and an adjacent capillary gap section has a length which is at least the width of said capillary gap section.

23. A micro fluidic device as claimed in claim 21 or claim 22, wherein the larger distance between the cartridge base and the lid in the flow break section is provided by a flow break indent in the cartridge base and/or in the lid, the width of the flow break indent, defined as the longest of the borderlines between the flow break section and the respective adjacent capillary gap sections, preferably being at least the width of the widest of the respective adjacent capillary gap sections.

24. A micro fluidic device as claimed in any one of claims 21-23, wherein the larger distance between the cartridge base and the lid in the flow break section is provided by a flow break indent in the cartridge base, said flow break indent having a depth which is at least 50 %, such as at least 75 % such as at least 95 %, such as more than 100 % of the depth of the channel shaped depression adjacent to said flow break indent.

25. A micro fluidic device as claimed in any one of claims 21-24, wherein said flow break indent forms edges to the surface of the flow channel, said edges preferably have edge angles of less than 135°, such as less than 115°, such as between 70 and 105°, such as between 85 and 95°.

26. A micro fluidic device as claimed in any one of claims 21-25, wherein the larger distance between the cartridge base and the lid in the flow break section is provided by a flow break indent in the cartridge base and/or in the lid, the depth of the flow break indent, preferably being at least twice, such as at least 4 times, such as at least 6 times, such as at least 10 times the maximal distance between the cartridge base and the lid in the adjacent capillary flow section, preferably the depth of the flow break indent is at least 0.5 $\mu$m, such as between 1 $\mu$m and 1 mm, such as between 5 $\mu$m and 400 $\mu$m such as between 25 $\mu$m and 200 $\mu$m.

27. A micro fluidic device as claimed in any one of claims 21-25, wherein the stepwise change in the distance between the catridge base and the lid to form the borderline between the flow break section and the adjacent capillary gap sections is sufficiently steep to provide a barrier to an advancing flow of liquid.

28. A micro fluidic device as claimed in any one of claims 21-27, wherein the stepwise change in the distance between the cartridge base and the lid to form the borderline between the flow break section and the adjacent capillary gap sections forms at least one edge, with an edge angle of less than 135° such as less than 115°, such as between 70 and 105°, such as between 85 and 95°.

29. A micro fluidic device as claimed in any one of claims 21-28, wherein the flow break sections comprise bonding material, such as glue or welding polymer which has flown into flow break sections while bonding the cartridge base and the lid, said bonding material preferably has a hydrophobic surface which is less hydrophilic than the surface of the lid and/or the cartridge base in the capillary gap sections.

30. A micro fluidic device as claimed in claim 29, wherein bonding material has penetrated into the flow channel.

31. A micro fluidic device as claimed in claim 29, wherein said device comprises at least one hydrophobic flow channel section with a surface formed by surfaces of the cartridge base and the lid, and wherein said flow channel section surface comprises at least one hydrophobic flow channel surface part formed by bonding material which has penetrated into the flow channel, and wherein said hydrophobic flow channel surface part is less hydrophilic than a flow channel surface part in a hydrophilic flow channel section adjacent to said hydrophobic flow channel section.

32. A micro fluidic device as claimed in any one of the preceding claims, wherein the cartridge base and the lid in the at least one flow break section are bonded to each other, the bonding material extending beyond the border between the interface between the cartridge base and the lid and into the flow channel in said flow break sections.

33. A micro fluidic device as claimed in claim 32, wherein the bonding material preferably has a hydrophobic surface which is less hydrophilic than the surface of the lid and/or the cartridge base in the capillary gap sections.

34. A micro fluidic device as claimed in claims 32, wherein said device comprises at least one hydrophobic flow channel section with a surface formed by surfaces of the cartridge base and the lid, and wherein said flow channel section surface comprises at least one hydrophobic flow channel surface part formed by bonding material which has penetrated into the flow channel, and wherein said hydrophobic flow channel surface part is less hydrophilic than a flow channel surface part in a hydrophilic flow channel section adjacent to said hydrophobic flow channel section.

35. A micro fluidic device as claimed in claims 34, wherein the at least one hydrophobic flow channel surface part has a convex shape or a concave shape.

36. A micro fluidic device as claimed in any one of claims 34-35, wherein said hydrophobic flow channel surface part is adjacent to a flow break section, said hydrophobic flow channel section comprises at least one pair of hydrophobic flow channel surface parts extending from respective borderlines between the interface sides on each side of the flow channel towards each other, and wherein the pair of hydrophobic flow channel surface parts preferably constitutes at least 5 %, such as at least 20 %, such as at least 30 %, such as at least 50 % of the hydrophobic flow channel section surface.

37. A method of producing a micro fluidic device as claimed in any one of claims 1 -36, comprising the steps of i) providing a cartridge base with a channel shaped depression, ii) providing a lid for said depression, and iii) bonding the cartridge base and the lid to each other to form a flow channel so that the interface between the cartridge base and the lid, adjacent to and along the flow channel comprises at least two capillary gap sections in the form of a gap between the lid and the cartridge base, separated by a flow break section, which flow break section has a surface which is less hydrophilic than the surface of the cartridge base and lid in the capillary gap sections and provides a barrier to a capillary flow of liquid along adjoining capillary gap sections.

38. A method as claimed in claim 37, wherein said cartridge base and said lid independently of each other are made from a material selected from the group consisting of glass, ceramics, metals, silicon and polymers, preferably said cartridge base and said lid being made from a polymer, more preferably an injection mouldable polymer, such as a polymer selected from the group consisting of acrylonitrile-butadiene-styrene copolymer, polycarbonate, polydimethylsiloxane (PDMS), polyethylene, polymethylmethacrylate (PMMA), polymethylpentene, polypropylene, polystyrene, polysulfone, polytetrafluoroethylene (PTFE), polyurethane, polyvinylchloride (PVC), polyvinylidine fluoride, nylon, styrene-acryl copolymers and mixtures thereof,

39. A method as claimed claim 37 or claim 38, wherein said cartridge base and said lid are bonded using one or more of the bonding methods selected from the group consisting of adhesives, mechanical sealing, solvent assisted joining, gluing and welding, such as ultrasonic welding, impulse welding, laser mask welding and heat welding.

40. A method as claimed in any one of claims 37-39, wherein the bonding step includes bonding the cartridge base and the lid to each other in at least a first and a second bonding line extending respectively on a first and a second side of the channel shaped depression; and the bonding material extends beyond the border between the interface of the cartridge base and the lid and into the flow channel in at least one flow break section.

41. A method as claimed in claim 40, wherein the bonding material preferably has a hydrophobic surface which is less hydrophilic than the surface of the lid and/or the cartridge base in the capillary gap sections.

42. A method as claimed in any one of claims 37-41, wherein the lid has a depression, such as a channel shaped depression.

43. A method as claimed in any one of claims 37-42, wherein said method further comprises a step of providing a plurality of cartridge bases and/or lids and bonding said plurality of cartridge base and/or lids to each other to form flow channels.

44. A method as claimed in any one of claims 37-43, wherein said method comprises the step of providing at least one of the cartridge bases and lids with an opening or a depression leading to an edge of the cartridge base/lid, to thereby form a flow channel opening.

45. A method as claimed in any one of the claims 37-44, further comprising the step of treating at least one of the cartridge base and the lid to form at least one hydrophobic surface partbefore the bonding step, thereby forming a flow channel comprising at least one hydrophobic flow channel section with at least one hydrophobic surface part , which is less hydrophilic than a flow channel surface part in a hydrophilic flow channel section adjacent to said hydrophobic flow channel section, and wherein, in the bonding step, the cartridge base and lid are bonded in at least a first and a second bonding line extending respectively on a first and a second side of the channel shaped depression, so that the at least one hydrophobic surface part is adjacent to at least one of the bonding lines, said at least one hydrophobic surface part preferably extending from at least one bonding line to at least the closest edge of the channel shaped depression.

46. A method as claimed in claim 45, wherein said treating step comprises an activation treatment of at least one of the cartridge base and the lid to increase its surface energy, the at least one hydrophobic surface part being masked.

47. A method as claimed in claim 45, wherein said treating step comprises an activation treatment of at least one of the cartridge base and the lid to increase its surface energy by laser treating the at least one hydrophobic surface part.

48. A method as claimed in claim 45, wherein said treating step comprises an activation treatment of at least one of the cartridge base and the lid to increase its surface energy, by applying a layer of material with a lower surface energy onto the activation treated surface, and laser treating the activation treated surface surrounding the at least one hydrophobic surface part.

49. A method as claimed in any one of claims 46-48, wherein the activation treatment includes activation treatment of the surface of at least one channel shaped depression, preferably the channel shaped depression of the cartridge base.

50. A method as claimed in any one of claims 37-49, wherein the cartridge base is provided with at least one flow break indent adjacent to the channel shaped depression and/or the lid is provided with a flow break indent adjacent to the part of the lid to lie above the channel shaped depression, and wherein the cartridge base and the lid are bonded in at least a first and a second bonding line extending respectively on a first and a second side of the channel shaped depression so that the flow break indent is adjacent to or extends into the bonding.

51. A method as claimed in claim 50, wherein the cartridge base and the lid are bonded so that bonding material, such as glue or welding polymer flows into a flow break section provided by the gap between the cartridge base and the lid at the flow break indent.

52. A method as claimed in claim 51, wherein bonding material has penetrated into the flow channel.


**Patentansprüche**

1. Mikrofluidelement, einen Strömungskanal (3) mit einer Berührungsfläche zwischen einem Kartuschenunterteil und einem Deckel umfassend, wobei das Kartuschenunterteil eine kanalförmige Vertiefung aufweist und der Deckel mit dem Kartuschenunterteil verbunden ist, um den Strömungskanal zu bilden, und wobei die Berührungsfläche zwischen dem Kartuschenunterteil und dem Deckel, benachbart dem und entlang des Strömungskanals, mindestens zwei Bereiche mit einem kapillaren Spalt (4) in Form eines Spaltes zwischen dem Deckel und dem Kartuschenunterteil aufweist, die durch einen Strömungsabrissabschnitt (5) voneinander getrennt sind, welcher eine Oberfläche hat, die weniger hydrophil ist als die Oberfläche des Kartuschenunterteils und des Deckels in den Bereichen mit kapillarem Spalt, und eine Sperre für die Kapillarströmung der Flüssigkeit entlang aneinandergrenzender Bereiche mit kapillarem Spalt bildet.

2. Mikrofluidelement nach Anspruch 1, wobei die Berührungsfläche eine erste Berührungsflächenseite auf einer ersten Seite des Strömungskanals und eine zweite Berührungsflächenseite auf einer zweiten Seite des Strömungskanals aufweist, wobei die Strömungsabrissabschnitte sowohl auf der ersten als auch auf der zweiten Seite der Berührungsfläche vorhanden sind.

3. Mikrofluidelement nach einem der vorangehenden Ansprüche, wobei die Berührungsfläche eine erste Berührungsflächenseite auf einer ersten Seite des Strömungskanals und eine zweite Berührungsflächenseite auf einer zweiten Seite des Strömungskanals aufweist, wobei die erste und zweite Berührungsflächenseite jeweils eine Länge hat, die durch die Länge der Grenzlinie zwischen der zugehörigen Berührungsflächenseite und dem Strömungskanal definiert ist, und wobei die Strömungsabrissabschnitte der zugehörigen Berührungsflächenseiten eine Gesamtlänge (die Summe der entsprechenden Längen der Strömungsabrissabschnitte) hat von bis zu ungefähr 95 %, wie bis zu ungefähr 50 %, wie bis zu ungefähr 25 %, wie zwischen $10^{-4}$ % und 10 %, wie zwischen 0.01 und 1 % der Länge der Berührungsflächenseiten haben.

4. Mikrofluidelement nach einem der vorangehenden Ansprüche, wobei die Berührungsflächenseite aus Bereichen mit kapillarem Spalt und mindestens einem Abrissabschnitt, bevorzugt einer Vielzahl von Abrissabschnitten besteht.

5. Mikrofluidelement nach einem der vorangehenden Ansprüche, wobei jeder Strömungsabrissabschnitt eine Länge von bis zu 500 $\mu$m, wie zwischen 1 und 300 $\mu$m, zum Beispiel von 5 bis 200 $\mu$m hat.

6. Mikrofluidelement nach einem der vorangehenden Ansprüche, wobei die Berührungsflächenseite zwischen dem Kartuschenunterteil und dem Deckel zwei oder mehr Strömungsabrissabschnitte und/oder zwei oder mehr Bereiche mit kapillarem Spalt aufweist, und wobei die Strömungsabrissabschnitte und/oder die Bereiche mit kapillarem Spalt unterschiedliche Größen haben.

7. Mikrofluidelement nach einem der vorangehenden Ansprüche, wobei die Berührungsfläche eine erste Berührungsflächenseite auf einer ersten Seite des Strömungskanals und eine zweite Berührungsflächenseite auf einer zweiten Seite des Strömungskanals aufweist, wobei die erste und zweite Berührungsflächenseite jeweils eine Länge hat, die durch die Länge der Grenzlinie zwischen der Berührungsflächenseite und dem Strömungskanal definiert ist, und wobei jeder der Bereiche mit kapillarem Spalt eine Länge hat, die mindestens so lang ist wie der längste Strömungsabrissabschnitt, der dem Bereich mit kapillarem Spalt benachbart ist.

8. Mikrofluidelement nach einem der vorangehenden Ansprüche, wobei die Bereiche mit kapillarem Spalt eine Länge von mindestens 5 $\mu$m, wie mindestens 20 $\mu$m, wie mindestens 50 $\mu$m, wie mindestens 500 $\mu$m, wie bis zu 25 mm, wie bis zu 10 mm haben.

9. Mikrofluidelement nach einem der vorangehenden Ansprüche, wobei die Bereiche mit kapillarem Spalt eine Breite senkrecht zu der Grenzlinie zwischen der Berührungsflache und dem Strömungskanal haben, wobei die Breite mindestens 0.5 $\mu$m, wie mindestens 1 $\mu$m, wie mindestens 5 $\mu$m, wie mindestens 50 $\mu$m, wie bis zu 5 mm, wie bis zu 1 mm, wie bis zu 500 $\mu$m ist.

10. Mikrofluidelement nach Anspruch 9, wobei die Breite über die Länge der Grenzlinie zwischen Berührungsflache und Strömungskanal variiert.

11. Mikrofluidelement nach einem der vorangehenden Ansprüche, wobei die Bereiche mit kapillarem Spalt einen Spaltabstand haben, der definiert ist als der Abstand zwischen dem Kartuschenunterteil und dem Deckel, senkrecht zum Kartuschenunterteil, und zwischen 0.1 $\mu$m und 400 $\mu$m, wie zwischen 4 und 80 $\mu$m, wie zwischen 6 und 40 $\mu$m beträgt.

12. Mikrofluidelement nach einem der vorangehenden Ansprüche, wobei die Oberfläche des Kartuschenunterteils im Strömungsabrissabschnitt weniger hydrophil ist als die Oberflächen des Kartuschenunterteils und des Deckels in den Bereichen mit kapillarem Spalt oder die Oberfläche des Deckels im Strömungsabrissabschnitt weniger hydrophil ist als die Oberflächen des Kartuschenunterteils und des Deckels in den Bereichen mit kapillarem Spalt.

13. Mikrofluidelement nach einem der vorangehenden Ansprüche, wobei die Oberfläche des Kartuschenunterteils und/oder des Deckels im Strömungsabrissabschnitt, bevorzugt sowohl des Kartuschenunterteils als auch des Deckels im Strömungsabrissabschnitt, eine Oberflächenenergie von weniger als 80, bevorzugt weniger als 73, wie weniger als 60, wie zwischen 20 und 50 Dyne/cm hat.

14. Mikrofluidelement nach einem der vorangehenden Ansprüche, wobei die Oberfläche von mindestens einem aus der Gruppe von Kartuschenunterteil und/oder Deckel in der Berührungsfläche zwischen Kartuschenunterteil und Deckel im Bereich mit kapillarem Spalt, eine Oberflächenenergie von mehr als 73, bevorzugt mehr als 75, wie mehr als 80, wie mehr als 85 Dyne/cm hat.

15. Mikrofluidelement nach einem der vorangehenden Ansprüche, wobei das Element mindestens einen hydrophoben Bereich des Strömungskanals mit einer Oberfläche, die durch die Oberflächen des Kartuschenunterteils und des Deckels geformt wird, aufweist, und wobei die Oberfläche des Strömungskanalbereiches mindestens einen hydrophoben Strömungskanaloberflächenteil aufweist, der weniger hydrophil ist als ein Strömungskanaloberflächenteil I in einem hydrophilen Strömungskanalbereich der dem hydrophoben Strömungskanalbereich benachbart ist.

16. Mikrofluidelement nach Anspruch 15, wobei der hydrophobe Strömungskanaloberflächenteil dem Strömungsabrissabschnitt benachbart ist, wobei der hydrophobe Strömungskanaloberflächenteil bevorzugt mindestens ein Paar von hydrophoben Strömungskanaloberflächenteilen aufweist, welche sich von den zugehörigen Grenzlinien zwischen den Berührungsflächen beiderseits des Strömungskanals aufeinander zugehend erstrecken, und wobei das Paar von hydrophoben Strömungskanaloberflächenteilen bevorzugt mindestens 5 %, wie mindestens 20 %, wie mindestens 30 %, wie mindestens 50 % der hydrophoben Strömungskanalbereichsoberfläche ausmacht.

17. Mikrofluidelement nach Anspruch 15, wobei der hydrophobe Strömungskanalbereich einen hydrophoben Strömungskanaloberflächenteil aufweist, welcher bevorzugt mindestens 50 %, wie mindestens 80 %, wie mindestens 90 %, wie bis zur Gesamtheit der hydrophoben Strömungskanalbereichsoberfläche ausmacht.

18. Mikrofluidelement nach einem der Ansprüche 15 bis 17, wobei der oder die hydrophoben Strömungskanalbereich (e) eine Länge entlang der Strömungsrichtung hat/haben, welche bis zu 500 $\mu$m, wie zwischen 1 und 300 $\mu$m, wie zwischen 5 und 200 $\mu$m ist, und wobei die Länge des oder der hydrophoben Strömungskanalbereiche(s) bevorzugt der Länge des oder der benachbarten Strömungsabrissabschnitte(s) entspricht.

19. Mikrofluidelement nach einem der Ansprüche 15 bis 18, wobei der oder die hydrophilen Strömungskanalbereich(e) eine Länge entlang der Strömungsrichtung hat/haben, welche mindestens 5 $\mu$m, wie mindestens 20 $\mu$m, wie mindestens 50 $\mu$m, wie mindestens 500 $\mu$m ist, und wobei die Länge des oder der hydrophilen Strömungskanalbereiche (s) bevorzugt der Länge des oder der benachbarten Bereiche(s) mit kapillarem Spalt entspricht.

20. Mikrofluidelement nach einem der Ansprüche 15 bis 19, wobei die Oberfläche des hydrophoben Strömungskanalbereiches ausreichend hydrophob ist, um eine Strömungsverzögerung der Flüssigkeitsströmung verglichen mit der Strömungsgeschwindigkeit der Flüssigkeit in den benachbarten hydrophilen Strömungskanalbereichen zu gewährleisten.

21. Mikrofluidelement nach einem der vorangehenden Ansprüche, wobei das Kartuschenunterteil und der Deckel in dem mindestens einem Strömungsabrissabschnitt einen größeren Abstand zueinander haben als in den benachbarten Bereichen mit kapillarem Spalt, und wobei mindestens eine Grenzlinie zwischen dem Strömungsabrissabschnitt und den angrenzenden Bereichen mit kapillarem Spalt bevorzugt durch eine stufenweise Änderung des Abstands zwischen Kartuschenunterteil und Deckel gebildet wird.

22. Mikrofluidelement nach Anspruch 21, wobei die Grenzlinie zwischen dem Strömungsabrissabschnitt und einem benachbarten Bereich mit kapillarem Spalt eine Länge von mindestens der Breite eines Bereiches mit kapillarem Spalt hat.

23. Mikrofluidelement nach Anspruch 21 oder 22, wobei der größere Abstand zwischen Kartuschenunterteil und dem Deckel im Strömungsabrissabschnitt durch eine Strömungsabrissvertiefung im Kartuschenunterteil und/oder im Deckel gebildet wird, wobei die Breite dieser Strömungsabrissvertiefung, die definiert ist als die längste der Grenzlinien zwischen dem Strömungsabrissabschnitt und den zugehörigen benachbarten Bereichen mit kapillarem Spalt, bevorzugt mindestens die Breite des breitesten der zugehörigen benachbarten Bereiche mit kapillarem Spalt ist.

24. Mikrofluidelement nach einem der Ansprüche 21 bis 23, wobei der größere Abstand zwischen Kartuschenunterteil und Deckel im Strömungsabrissabschnitt durch eine Strömungsabrissvertiefung im Kartuschenunterteil gebildet wird, und wobei die Strömungsabrissvertiefung eine Tiefe hat von mindestens 50 %, wie mindestens 75 %, wie mindestens 95 %, wie mehr als 100 % der Tiefe der kanalförmigen Vertiefung benachbart der Strömungsabrissvertiefung.

25. Mikrofluidelement nach einem der Ansprüche 21 bis 24, wobei die Strömungsabrissvertiefung die Kanten zu der Oberfläche des Strömungskanals bildet, wobei die Kanten bevorzugt Kantenwinkel von weniger als 135°, wie weniger als 115°, wie zwischen 70 und 105°, wie zwischen 85 und 95° haben.

26. Mikrofluidelement nach einem der Ansprüche 21 bis 25, wobei der größere Abstand zwischen Kartuschenunterteil und dem Deckel im Strömungsabrissabschnitt durch eine Strömungsabrissvertiefung im Kartuschenunterteil und/oder im Deckel gebildet wird, wobei die Tiefe dieser Strömungsabrissvertiefung bevorzugt mindestens das doppelte, wie mindestens das vierfache, wie mindestens das sechsfache, wie mindestens das zehnfache des maximalen Abstands zwischen dem Kartuschenunterteil und dem Deckel in den benachbarten Bereichen mit kapillarem Spalt ist, wobei die Tiefe der Strömungsabrissvertiefung bevorzugt mindestens 0.5 $\mu$m, wie zwischen 1 $\mu$m und 1 mm, wie zwischen 5 $\mu$m und 400 $\mu$m, wie 25 $\mu$m bis 200 $\mu$m ist.

27. Mikrofluidelement nach einem der Ansprüche 21 bis 25, wobei die stufenweise Veränderung des Abstandes zwischen Kartuschenunterteil und Deckel mit dem Ziel eine Grenzlinie zwischen dem Strömungsabrissabschnitt und den benachbarten Bereichen mit kapillarem Spalt zu bilden, ausreichend steil ist um ein Hindernis für einen voranschreitenden Flüssigkeitsstrom darzustellen.

28. Mikrofluidelement nach einem der Ansprüche 21 bis 27, wobei die stufenweise Veränderung des Abstandes zwischen Kartuschenunterteil und Deckel mit dem Ziel eine Grenzlinie zwischen dem Strömungsabrissabschnitt und den benachbarten Bereichen mit kapillarem Spalt zu bilden, mindestens eine Kante bildet mit einem Kantenwinkel von weniger als 135°, wie weniger als 115°, wie zwischen 70 und 105°, wie zwischen 85 und 95°.

29. Mikrofluidelement nach einem der Ansprüche 21 bis 28, wobei die Strömungsabrissabschnitte Verbindungsmaterial aufweisen, wie Klebstoff oder Schweißpolymer, welches während des Verbindens von Kartuschenunterteil und Deckel in die Strömungsabrissabschnitte hineingeflossen ist, wobei das Verbindungsmaterial bevorzugt eine hydrophobe Oberfläche aufweist, welche weniger hydrophil ist als die Oberfläche des Deckels und/oder des Kartuschenunterteils in den Bereichen mit den kapillarem Spalt.

30. Mikrofluidelement nach Anspruch 29, wobei Verbindungsmaterial in den Strömungskanal eingedrungen ist.

31. Mikrofluidelement nach Anspruch 29, wobei das Element mindestens einen hydrophoben Strömungskanalbereich mit einer Oberfläche, die durch die Oberflächen des Kartuschenunterteils und des Deckels geformt wird, aufweist und wobei der Strömungskanalbereich mindestens ein hydrophobes Strömungskanaloberflächenteil, welches durch Verbindungsmaterial, welches in den Strömungskanal eingedrungen ist, geformt wurde, aufweist und wobei das hydrophobe Strömungskanaloberflächenteil weniger hydrophil ist als ein Strömungskanaloberflächenteil in einem hydrophilen Strömungskanalbereich, welcher benachbart ist zum hydrophoben Strömungskanalbereich.

32. Mikrofluidelement nach einem der vorangehenden Ansprüche, wobei das Kartuschenunterteil und der Deckel in dem mindestens einem Strömungsabrissabschnitt miteinander verbunden sind, und wobei sich das Verbindungsmaterial über die Grenze zwischen der Berührungsfläche zwischen Kartuschenunterteil und Deckel hinaus in die Strömungsabrissabschnitte im Strömungskanal ausdehnt.

33. Mikrofluidelement nach Anspruch 32, wobei das Verbindungsmaterial bevorzugt eine hydrophobe Oberfläche hat, welche weniger hydrophil ist als die Oberfläche des Deckels und/oder des Kartuschenunterteils in den Bereichen mit kapillarem Spalt.

34. Mikrofluidelement nach Anspruch 32, wobei das Element mindestens einen hydrophoben Strömungskanalbereich mit einer Oberfläche, die durch die Oberflächen des Kartuschenunterteils und des Deckels geformt wird, aufweist und wobei die Oberfläche des Strömungskanalbereichs mindestens ein hydrophobes Strömungskanaloberflächenteil, welches durch Verbindungsmaterial, welches in den Strömungskanal eingedrungen ist, geformt wurde, aufweist und wobei das hydrophobe Strömungskanaloberflächenteil weniger hydrophil ist als ein Strömungskanaloberflächenteil in einem hydrophilen Strömungskanalbereich, welcher benachbart ist zum hydrophoben Strömungskanalbereich.

35. Mikrofluidelement nach Anspruch 34, wobei das mindestens eine hydrophobe Strömungskanaloberflächenteil eine konvexe oder eine konkave Form hat.

36. Mikrofluidelement nach einem der Ansprüche 34 oder 35, wobei das hydrophobe Strömungskanaloberflächenteil benachbart ist zum Strömungsabrissabschnitt, wobei das hydrophobe Strömungskanaloberflächenteil mindestens ein Paar von hydrophoben Strömungskanaloberflächenteilen, welche sich von den zugehörigen Grenzlinien zwischen den Berührungsflächen auf jeder Seite des Strömungskanals zu einander hin erstrecken, aufweist und wobei das Paar von hydrophoben Strömungskanaloberflächenteilen bevorzugt mindestens 5 %, wie mindestens 20 %, wie mindestens 30 %, wie mindestens 50 % der hydrophoben Strömungskanalbereichsoberfläche ausmacht.

37. Verfahren zur Herstellung eines Mikrofluidelements nach einem der Ansprüche 1 bis 36, umfassend die Schritte i) Bereitstellung eines Kartuschenunterteils mit einer kanalförmigen Vertiefung, ii) Bereitstellung eines Deckels für die Vertiefung, und iii) Verbinden des Kartuschenunterteils mit dem Deckel, so dass ein Strömungskanal dergestalt gebildet wird, dass die Berührungsfläche zwischen Kartuschenunterteil und Deckel, benachbart zum und entlang des Strömungskanal(s), mindestens zwei Bereiche mit kapillarem Spalt in der Form eines Spaltes zwischen Deckel und Kartuschenunterteil, die durch einen Strömungsabrissabschnitt voneinander getrennt sind, welcher eine Oberfläche hat, die weniger hydrophil ist als die Oberfläche des Kartuschenunterteils und des Deckels in den Bereichen mit kapillarem Spalt, und die ein Hindernis darstellt für einen Kapillarfluss einer Flüssigkeit entlang der angrenzenden Bereiche mit kapillarem Spalt, aufweist.

38. Verfahren nach Anspruch 37, wobei das Kartuschenunterteil und der Deckel unabhängig voneinander aus einem Material gemacht wurden, welches aus der Gruppe, bestehend aus Glas, Keramik, Metallen, Silikonen und Polymeren, ausgewählt wurde, wobei bevorzugt Kartuschenunterteil und Deckel aus einem Polymer hergestellt werden, bevorzugter aus einem spritzgießbaren Polymer, zum Beispiel aus einem Polymer ausgewählt aus der Gruppe bestehend aus Acrylnitril-Butadien-Styrol-Copolymer, Polycarbonat, Polydimethylsiloxan (PDMS), Polyethylen, Polymethylmethacrylat (PMMA), Polymethylpenten, Polypropylen, Polystyrol, Polysulfon, Polytetrafluorethylen (PTFE), Polyurethan, Polyvinylchlorid (PVC), Polyvinylidenfluorid, Nylon, Styrol-Acryl-Copolymeren und deren Mischungen.

39. Verfahren nach Anspruch 37 oder 38, wobei das Kartuschenunterteil und der Deckel verbunden wurden, indem eine oder mehrere Verbindungsmethoden verwendet wurden, die aus einer Gruppe ausgewählt wurden, welche aus Klebemitteln, mechanischem Versiegeln, Lösungsmittel unterstütztem Verbinden, Kleben und Schweißen, wie zum Beispiel Ultraschallschweißen, Wärmeimpulsschweißen, Lasermaskenschweißen und Hitzeschweißen, besteht.

40. Verfahren nach einem der Ansprüche 37 bis 39, wobei der Verbindungsschritt das Verbinden des Kartuschenunterteils und des Deckels miteinander in mindestens einer ersten und einer zweiten Verbindungslinie einschließt, welche sich über die zugehörige erste beziehungsweise zweite Seite einer kanalförmigen Vertiefung erstreckt, und das Verbindungsmaterial sich über die Grenze zwischen der Berührungsfläche des Kartuschenunterteils und des Deckel hinaus in mindestens einen Strömungsabrissabschnitt im Strömungskanal erstreckt.

41. Verfahren nach Anspruch 40, wobei das Verbindungsmaterial bevorzugt eine hydrophobe Oberfläche hat, welche weniger hydrophil ist als die Oberfläche des Deckels und/oder des Kartuschenunterteils in den Bereichen mit kapillarem Spalt.

42. Verfahren nach einem der Ansprüche 37 bis 41, wobei der Deckel eine Vertiefung hat, zum Beispiel eine kanalförmige Vertiefung.

43. Verfahren nach einem der Ansprüche 37 bis 42, wobei das Verfahren weiterhin einen Schritt zur Bereitstellung einer Vielzahl von Kartuschenunterteilen und/oder Deckeln und zum Verbinden dieser Vielzahl von Kartuschenunterteilen und/oder Deckeln miteinander dergestalt, dass sie Strömungskanäle bilden, umfasst.

44. Verfahren nach einem der Ansprüche 37 bis 43, wobei das Verfahren einen Schritt umfasst, dass mindestens eins dieser Kartuschenunterteile und Deckel mit einer Öffnung oder einer Vertiefung versehen wird, welche zu einer Kante des Kartuschenunterteils/des Deckels führt und **dadurch** eine Strömungskanalöffnung bildet.

45. Verfahren nach einem der Ansprüche 37 bis 44, wobei das Verfahren weiterhin einen Schritt umfasst, der aus der Behandlung des Kartuschenunterteils oder des Deckels oder beider dergestalt besteht, dass Kartuschenunterteil und Deckel vor dem Verbindungsschritt mindestens einen hydrophoben Oberflächenteil bilden, wodurch sie einen Strömungskanal bilden, der mindestens einen hydrophoben Strömungskanalbereich mit mindestens einem hydrophoben Oberflächenteil, welcher weniger hydrophil ist als ein Strömungskanaloberflächenteil in einem hydrophilen Strömungskanalbereich, welcher an den hydrophoben Strömungskanalbereich angrenzt, umfasst, und wobei im Verbindungsschritt das Kartuschenunterteil und der Deckel in mindestens einer ersten und einer zweiten Verbindungslinie, welche sich über die zugehörige erste beziehungsweise zweite Seite der kanalförmigen Vertiefung erstrecken, verbunden werden, so dass der mindestens eine hydrophobe Oberflächenteil benachbart ist zur mindestens einen Verbindungslinie, wobei dieser eine hydrophobe Oberflächenteil sich bevorzugt von mindestens einer Verbindungslinie zu mindestens der nächst gelegenen Kante der kanalförmigen Vertiefung erstreckt.

46. Verfahren nach Anspruch 45, wobei der Behandlungsschritt eine aktivierende Behandlung des Kartuschenunterteils oder des Deckels oder beider umfasst, um die Oberflächenenergie zu vergrößern, wobei der mindestens eine hydrophobe Oberflächenteil während des aktivierenden Behandlungsschritt abgedeckt wird.

47. Verfahren nach Anspruch 45, wobei der Behandlungsschritt eine aktivierende Behandlung des Kartuschenunterteils oder des Deckels oder beider umfasst, um die Oberflächenenergie des mindestens einen hydrophoben Oberflächenteils mittels Laserbehandlung zu vergrößern.

**48.** Verfahren nach Anspruch 45, wobei der Behandlungsschritt eine aktivierende Behandlung des Kartuschenunterteils oder des Deckels oder beider, um die Oberflächenenergie zu vergrößern, umfasst, indem eine Schicht von Material mit einer niedrigeren Oberflächenenergie auf die aktivierend behandelte Oberfläche aufgebracht wird, und die aktivierend behandelte Oberfläche, die den mindestens einen hydrophoben Oberflächenteil umgibt, mit Laser behandelt wird.

**49.** Verfahren nach einem der Ansprüche 46 bis 48, wobei die aktivierende Behandlung die aktivierende Behandlung der Oberfläche mindestens einer kanalförmigen Vertiefung, bevorzugt der kanalförmigen Vertiefung des Kartuschenunterteils, einschließt.

**50.** Verfahren nach einem der Ansprüche 37 bis 49, wobei das Kartuschenunterteil mit mindestens einer Strömungsabrissvertiefung, welche der kanalförmigen Vertiefung benachbart ist, bereitgestellt wird und/oder der Deckel mit einer Strömungsabrissvertiefung, welche dem Teil des Deckels benachbart ist, welcher sich oberhalb der kanalförmigen Vertiefung befindet, bereitgestellt wird, und wobei das Kartuschenunterteil und der Deckel in mindestens einer ersten und einer zweiten Verbindungslinie, welche sich über die zugehörige erste beziehungsweise zweite Seite einer kanalförmigen Vertiefung erstrecken, so verbunden sind, dass die Strömungskanalvertiefung dem Verbindungsbereich benachbart ist oder in diesen hineinreicht.

**51.** Verfahren nach Anspruch 50, wobei das Kartuschenunterteil und der Deckel so verbunden sind, dass das Verbindungsmaterial, wie zum Beispiel Klebstoff oder Schweißpolymer, in den Strömungsabrissabschnitt, welcher durch den Spalt zwischen dem Kartuschenunterteil und dem Deckel an der Strömungsabrissvertiefung bereitgestellt wird, fließt.

**52.** Verfahren nach Anspruch 51, wobei das Verbindungsmaterial in den Strömungskanal eingedrungen ist.

**Revendications**

**1.** Dispositif microfluidique comprenant un canal d'écoulement (3) avec une interface entre une base de cartouche et un couvercle, dans lequel la base de cartouche comprend un creux en forme de canal et le couvercle est lié à ladite base de cartouche pour former le canal d'écoulement, et dans lequel l'interface entre la base de cartouche et le couvercle, à proximité et le long du canal d'écoulement, comprend au moins deux sections d'espace capillaire (4) se présentant sous la forme d'un espace entre le couvercle et la base de cartouche, séparées par une section de rupture d'écoulement (5), ladite section de rupture d'écoulement ayant une surface qui est moins hydrophile que la surface de la base de cartouche et du couvercle dans les sections d'espace capillaire et faisant barrage à l'écoulement capillaire d'un liquide le long des sections d'espace capillaire attenantes.

**2.** Dispositif microfluidique selon la revendication 1, dans lequel l'interface comprend un premier côté d'interface sur un premier côté du canal d'écoulement, et un deuxième côté d'interface sur un deuxième côté du canal d'écoulement, lesdites sections de rupture d'écoulement se trouvant sur chacun desdits premier et deuxième côtés d'interface.

**3.** Dispositif microfluidique selon l'une quelconque des revendications précédentes, dans lequel l'interface comprend un premier côté d'interface sur un premier côté du canal d'écoulement et un deuxième côté d'interface sur un deuxième côté du canal d'écoulement, lesdits premier et deuxième côtés d'interface ont chacun une longueur définie comme étant la longueur de la limite entre ledit côté d'interface respectif et ledit canal d'écoulement, et ladite ou lesdites sections de rupture d'écoulement desdits côtés d'interface respectifs ont une longueur totale (la somme des longueurs respectives des sections de rupture d'écoulement) maximale d'environ 95 %, par exemple d'environ 50 %, par exemple d'environ 25 %, par exemple comprise entre $10^{-4}$ % et 10 %, par exemple comprise entre 0,01 et 1 % de la longueur dudit côté d'interface.

**4.** Dispositif microfluidique selon l'une quelconque des revendications précédentes, dans lequel ladite interface est constituée de sections d'espace capillaire et d'au moins une section de rupture, de préférence une pluralité de sections de rupture.

**5.** Dispositif microfluidique selon l'une quelconque des revendications précédentes, dans lequel chaque section de rupture d'écoulement a une longueur maximale de 500 $\mu$m, par exemple comprise entre 1 et 300 $\mu$m, par exemple

comprise entre 5 et 200 $\mu$m.

6. Dispositif microfluidique selon l'une quelconque des revendications précédentes, dans lequel ladite interface entre la base de cartouche et le couvercle comprend deux ou plusieurs sections de rupture d'écoulement et/ou deux ou plusieurs sections d'espace capillaire, et lesdites sections de rupture d'écoulement et/ou lesdites sections d'espace capillaire sont de taille différente.

7. Dispositif microfluidique selon l'une quelconque des revendications précédentes, dans lequel l'interface comprend un premier côté d'interface sur un premier côté du canal d'écoulement, et un deuxième côté d'interface sur un deuxième côté du canal d'écoulement, ledit premier et ledit deuxième côté d'interface ont chacun une longueur définie comme étant la longueur de la limite entre le côté d'interface et le canal d'écoulement, et dans lequel chacune desdites sections d'espace capillaire a une longueur qui est au moins égale à la plus longue des sections de rupture d'écoulement adjacentes auxdites sections d'espace capillaire.

8. Dispositif microfluidique selon l'une quelconque des revendications précédentes, dans lequel les sections d'espace capillaire ont une longueur d'au moins 5 $\mu$m, par exemple d'au moins 20 $\mu$m, par exemple d'au moins 50 $\mu$m, par exemple d'au moins 500 $\mu$m, par exemple pouvant aller jusqu'à 25 mm, par exemple pouvant aller jusqu'à 10 mm.

9. Dispositif microfluidique selon l'une quelconque des revendications précédentes, dans lequel les sections d'espace capillaire ont une largeur perpendiculaire à la limite entre l'interface et le canal d'écoulement, ladite largeur mesurant au moins 0,5 $\mu$m, par exemple au moins 1 $\mu$m, par exemple au moins 5 $\mu$m, par exemple au moins 50 $\mu$m, par exemple pouvant aller jusqu'à 5 mm, par exemple pouvant aller jusqu'à 1 mm, par exemple pouvant aller jusqu'à 500 $\mu$m.

10. Dispositif microfluidique selon la revendication 9, dans lequel ladite largeur varie le long de la limite entre l'interface et le canal d'écoulement.

11. Dispositif microfluidique selon l'une quelconque des revendications précédentes, dans lequel les sections d'espace capillaire ont une distance d'espace définie comme étant la distance entre la base de cartouche et le couvercle, et perpendiculaire à la base de cartouche, ladite distance d'espace mesurant entre 0,1 $\mu$m et 400 $\mu$m, par exemple entre 4 $\mu$m et 80 $\mu$m, par exemple entre 6 $\mu$m et 40 $\mu$m.

12. Dispositif microfluidique selon l'une quelconque des revendications précédentes, dans lequel la surface de la base de cartouche dans les sections de rupture d'écoulement est moins hydrophile que les surfaces de la base de cartouche et du couvercle dans les sections d'espace capillaire, ou la surface du couvercle dans les sections de rupture d'écoulement est moins hydrophile que les surfaces de la base de cartouche et du couvercle dans les sections d'espace capillaire.

13. Dispositif microfluidique selon l'une quelconque des revendications précédentes, dans lequel la surface d'au moins soit la base de cartouche, soit le couvercle dans les sections de rupture d'écoulement et de préférence les deux, a une tension interfaciale inférieure à 80, de préférence inférieure à 73, par exemple inférieure à 60, par exemple comprise entre 20 et 50 dynes/cm.

14. Dispositif microfluidique selon l'une quelconque des revendications précédentes, dans lequel la surface d'au moins soit la base de cartouche, soit le couvercle dans l'interface entre la base de cartouche et le couvercle dans les sections d'espace capillaire a une tension interfaciale supérieure à 73, de préférence supérieure à 75, par exemple supérieure à 80, par exemple supérieure à 85 dynes/cm.

15. Dispositif microfluidique selon l'une quelconque des revendications précédentes, dans lequel ledit dispositif comprend au moins une section de canal d'écoulement hydrophobe avec une surface formée par les surfaces de la base de cartouche et du couvercle, et dans lequel ladite surface de section de canal d'écoulement comprend au moins une partie de surface de section de canal d'écoulement hydrophobe qui est moins hydrophile qu'une partie de surface de canal d'écoulement dans une section de canal d'écoulement hydrophile adjacente à ladite section de canal d'écoulement hydrophobe.

16. Dispositif microfluidique selon la revendication 15, dans lequel ladite partie de surface de canal d'écoulement hydrophobe est adjacente à une section de rupture d'écoulement, ladite section de canal d'écoulement hydrophobe comprend de préférence au moins une paire de parties de surface de canal d'écoulement hydrophobes s'étendant à partir des limites respectives entre les côtés d'interface de chaque côté du canal d'écoulement l'une vers l'autre, et dans lequel la paire de parties de surface de canal d'écoulement hydrophobes constitue de préférence au moins 5 %, par exemple au moins 20 %, par exemple au moins 30 %, par exemple au moins 50 % de la surface de section de canal d'écoulement hydrophobe.

17. Dispositif microfluidique selon la revendication 15, dans lequel ladite section de canal d'écoulement hydrophobe comprend une partie de surface de canal d'écoulement hydrophobe, ladite partie de surface de canal d'écoulement hydrophobe constitue de préférence au moins 50 %, par exemple au moins 80 %, par exemple au moins 90 %, par exemple la totalité de la surface de section de canal d'écoulement hydrophobe.

18. Dispositif microfluidique selon l'une quelconque des revendications 15 à 17, dans lequel la ou les sections de canal d'écoulement hydrophobes ont une longueur dans le sens de l'écoulement qui peut aller jusqu'à 500 $\mu$m, par exemple comprise entre 1 et 300 $\mu$m, par exemple comprise entre 5 et 200 $\mu$m, et dans lequel la longueur de la ou des sections de canal d'écoulement hydrophobes correspond de préférence à la longueur de la ou des sections de rupture d'écoulement adjacentes.

19. Dispositif microfluidique selon l'une quelconque des revendications 15 à 18, dans lequel la ou les sections de canal d'écoulement hydrophiles ont une longueur dans le sens de l'écoulement d'au moins 5 $\mu$m, par exemple d'au moins 20 $\mu$m, par exemple d'au moins 50 $\mu$m, par exemple d'au moins 500 $\mu$m, et dans lequel la longueur de la ou des sections de canal d'écoulement hydrophiles correspond de préférence à la longueur des sections d'espace capillaire adjacentes.

20. Dispositif microfluidique selon l'une quelconque des revendications 15 à 19 précédentes, dans lequel la surface de section de canal d'écoulement hydrophobe est suffisamment hydrophobe pour assurer un retard d'écoulement de l'écoulement d'un liquide dans le canal d'écoulement, par rapport à la vitesse d'écoulement du liquide dans la section de canal d'écoulement hydrophile adjacente.

21. Dispositif microfluidique selon l'une quelconque des revendications précédentes, dans lequel la base de cartouche et le couvercle dans l'au moins une section de rupture d'écoulement sont séparés par une distance plus importante que dans les sections d'espace capillaire adjacentes, et dans lequel au moins une limite entre la section de rupture d'écoulement et les sections d'espace capillaire adjacentes est formée de préférence par un changement progressif de la distance entre la base de cartouche et le couvercle.

22. Dispositif microfluidique selon la revendication 21, dans lequel la limite entre la section de rupture d'écoulement et une section d'espace capillaire adjacente a une longueur qui est au moins égale à la largeur de ladite section d'espace capillaire.

23. Dispositif microfluidique selon la revendication 21 ou la revendication 22, dans lequel la distance plus importante entre la base de cartouche et le couvercle dans la section de rupture d'écoulement est fournie par une échancrure de rupture d'écoulement dans la base de cartouche et/ou dans le couvercle, la largeur de l'échancrure de rupture d'écoulement, définie comme étant la plus longue des limites entre la section de rupture d'écoulement et les sections d'espace capillaire adjacentes respectives, étant de préférence au moins égale à la largeur de la plus large des sections d'espace capillaire adjacentes respectives.

24. Dispositif microfluidique selon l'une quelconque des revendications 21 à 23, dans lequel la distance plus importante entre la base de cartouche et le couvercle dans la section de rupture d'écoulement est fournie par une échancrure de rupture d'écoulement dans la base de cartouche, ladite échancrure de rupture d'écoulement ayant une profondeur qui représente au moins 50 %, par exemple au moins 75 %, par exemple au moins 95 %, par exemple plus de 100 % de la profondeur du creux en forme de canal adjacent à ladite échancrure de rupture d'écoulement.

25. Dispositif microfluidique selon l'une quelconque des revendications 21 à 24, dans lequel ladite échancrure de rupture d'écoulement forme des bords pour la surface du canal d'écoulement, lesdits bords ayant de préférence des angles de bord inférieurs à 135°, par exemple inférieurs à 115°, par exemple compris entre 70 et 105°, par exemple compris entre 85 et 95°.

26. Dispositif microfluidique selon l'une quelconque des revendications 21 à 25, dans lequel la distance plus importante entre la base de cartouche et le couvercle dans la section de rupture d'écoulement est fournie par une échancrure de rupture d'écoulement dans la base de cartouche et/ou dans le couvercle, la profondeur de l'échancrure de rupture d'écoulement représentant au moins deux fois, par exemple au moins 4 fois, par exemple au moins 6 fois, par exemple au moins 10 fois la distance maximale entre la base de cartouche et le couvercle dans les sections d'espace capillaire adjacentes, la profondeur de l'échancrure de rupture d'écoulement mesurant de préférence au moins 0,5 $\mu$m, par exemple entre 1 $\mu$m et 1 mm, par exemple entre 5 $\mu$m et 400 $\mu$m, par exemple entre 25 $\mu$m et 200 $\mu$m.

27. Dispositif microfluidique selon l'une quelconque des revendications 21 à 25, dans lequel le changement progressif de la distance entre la base de cartouche et le couvercle pour former la limite entre la section de rupture d'écoulement et les sections d'espace capillaire adjacentes est suffisamment marqué pour faire barrage à l'avancée d'un écoulement de liquide.

28. Dispositif microfluidique selon l'une quelconque des revendications 21 à 27, dans lequel le changement progressif de la distance entre la base de cartouche et le couvercle pour former la limite entre la section de rupture d'écoulement et les sections d'espace capillaire adjacentes forme au moins un bord, avec un angle de bord inférieur à 135°, par exemple inférieur à 115°, par exemple compris entre 70 et 105°, par exemple compris entre 85 et 95°.

29. Dispositif microfluidique selon l'une quelconque des revendications 21 à 28, dans lequel les sections de rupture d'écoulement comprennent un matériau de liaison, tel qu'une colle ou un polymère de soudure qui s'est écoulé dans les sections de rupture d'écoulement tout en liant la base de cartouche et le couvercle, ledit matériau de liaison ayant une surface hydrophobe qui est moins hydrophile que la surface du couvercle et/ou de la base de cartouche dans les sections d'espace capillaire.

30. Dispositif microfluidique selon la revendication 29, dans lequel le matériau de liaison a pénétré dans le canal d'écoulement.

31. Dispositif microfluidique selon la revendication 29, dans lequel ledit dispositif comprend au moins une section de canal d'écoulement hydrophobe avec une surface formée par les surfaces de la base de cartouche et du couvercle, et dans lequel ladite surface de section de canal d'écoulement comprend au moins une partie de surface de canal d'écoulement hydrophobe formée par un matériau de liaison qui a pénétré dans le canal d'écoulement, et dans lequel ladite partie de surface de canal d'écoulement hydrophobe est moins hydrophile qu'une partie de surface de canal d'écoulement dans une section de canal d'écoulement hydrophile adjacente à ladite section de canal d'écoulement hydrophobe.

32. Dispositif microfluidique selon l'une quelconque des revendications précédentes, dans lequel la base de cartouche et le couvercle dans l'au moins une section de rupture d'écoulement sont liés l'un à l'autre, le matériau de liaison s'étendant au-delà de la limite entre l'interface entre la base de cartouche et le couvercle et jusqu'à l'intérieur du canal d'écoulement dans lesdites sections de rupture d'écoulement.

33. Dispositif microfluidique selon la revendication 32, dans lequel le matériau de liaison comporte de préférence une surface hydrophobe qui est moins hydrophile que la surface du couvercle et/ou de la base de cartouche dans les sections d'espace capillaire.

34. Dispositif microfluidique selon la revendication 32, dans lequel ledit dispositif comprend au moins une section de canal d'écoulement hydrophobe avec une surface formée par les surfaces de la base de cartouche et du couvercle, et dans lequel ladite surface de section de canal d'écoulement comprend au moins une partie de surface de canal d'écoulement hydrophobe formée par un matériau de liaison qui a pénétré dans le canal d'écoulement, et dans lequel ladite partie de surface de canal d'écoulement hydrophobe est moins hydrophile qu'une partie de surface de canal d'écoulement dans une section de canal d'écoulement hydrophile adjacente à ladite section de canal d'écoulement hydrophobe.

35. Dispositif microfluidique selon la revendication 34, dans lequel l'au moins une partie de surface de canal d'écoulement hydrophobe est de forme convexe ou de forme concave.

36. Dispositif microfluidique selon l'une quelconque des revendications 34 et 35, dans lequel ladite partie de surface de canal d'écoulement hydrophobe est adjacente à une section de rupture d'écoulement, ladite section de canal d'écoulement hydrophobe comprend au moins une paire de parties de surface de canal d'écoulement hydrophobes s'étendant à partir des limites respectives entre les côtés d'interface de chaque côté du canal d'écoulement l'une vers l'autre, et dans lequel la paire de parties de surface de canal d'écoulement hydrophobes constitue de préférence au moins 5 %, par exemple au moins 20 %, par exemple au moins 30 %, par exemple au moins 50 % de la surface de section de canal d'écoulement hydrophobe.

37. Méthode de production d'un dispositif selon l'une quelconque des revendications 1 à 36, comprenant les étapes consistant à i) fournir une base de cartouche dotée d'un creux en forme de canal, ii) fournir un couvercle pour ledit creux et iii) lier la base de cartouche et le couvercle l'un à l'autre pour former un canal d'écoulement de sorte que l'interface entre la base de cartouche et le couvercle, à proximité et le long du canal d'écoulement, comprenne au moins deux sections d'espace capillaire sous forme d'espace entre le couvercle et la base de cartouche, séparées par une section de rupture d'écoulement, ladite section de rupture d'écoulement comportant une surface qui est moins hydrophile que la surface de la base de cartouche et du couvercle dans les sections d'espace capillaire et faisant barrage à l'écoulement capillaire d'un liquide le long des sections d'espace capillaire attenantes.

38. Méthode selon la revendication 37, dans laquelle ladite base de cartouche et ledit couvercle sont réalisés indépendamment l'un de l'autre à partir d'un matériau choisi dans le groupe comprenant le verre, les céramiques, les métaux, le silicium et les polymères, ladite base de cartouche et ledit couvercle étant réalisés de préférence à partir d'un polymère, mieux encore d'un polymère pouvant être moulé par injection, par exemple, un polymère choisi dans le groupe constitué par un copolymère d'acrylonitrile-butadiène-styrène, le polycarbonate, le polydiméthylsiloxane (PDMS), le polyéthylène, le polyméthylméthacrylate (PMMA), le polyméthylpentène, le polypropylène, le polystyrène, le polysulfone, le polytétrafluoroéthylène (PTFE), le polyuréthane, le chlorure de polyvinyle (PVC), le fluorure de polyvinylidène, le nylon, les copolymères styrène-acryle et leurs mélanges.

39. Méthode selon la revendication 37 ou la revendication 38, dans laquelle ladite base de cartouche et ledit couvercle sont liés au moyen d'une ou plusieurs des méthodes de liaison choisies dans le groupe constitué par les adhésifs, les joints mécaniques, l'assemblage par solvant, le collage et le soudage, par exemple le soudage par ultrason, le soudage par impulsion, le soudage laser par masque et le thermosoudage.

40. Méthode selon l'une quelconque des revendications 37 à 39, dans laquelle l'étape de liaison consiste à lier la base de cartouche et le couvercle l'un à l'autre dans au moins une première et une deuxième ligne de liaison s'étendant respectivement sur un premier et un deuxième côté du creux en forme de canal, et le matériau de liaison s'étend au-delà de la limite entre l'interface de la base de cartouche et du couvercle et jusqu'à l'intérieur du canal d'écoulement dans au moins une section de rupture d'écoulement.

41. Méthode selon la revendication 40, dans laquelle le matériau de liaison présente de préférence une surface hydrophobe qui est moins hydrophile que la surface du couvercle et/ou de la base de cartouche dans les sections d'espace capillaire.

42. Méthode selon l'une quelconque des revendications 37 à 41, dans laquelle le couvercle présente un creux, par exemple un creux en forme de canal.

43. Méthode selon l'une quelconque des revendications 37 à 42, dans laquelle ladite méthode comprend en outre une étape consistant à fournir une pluralité de bases de cartouche et/ou de couvercles et à lier ladite pluralité de bases de cartouche et/ou de couvercles les uns aux autres pour former des canaux d'écoulement.

44. Méthode selon l'une quelconque des revendications 37 à 43, dans laquelle ladite méthode comprend l'étape consistant à pourvoir au moins soit les bases de cartouche soit les couvercles d'une ouverture ou d'un creux conduisant à un bord de la base ou du couvercle de cartouche, afin de former une ouverture de canal d'écoulement.

45. Méthode selon l'une quelconque des revendications 37 à 44, comprenant en outre l'étape qui consiste à traiter au moins soit la base de cartouche soit le couvercle pour former au moins une partie de surface hydrophobe avant l'étape de liaison, afin de former un canal d'écoulement comprenant au moins une section de canal d'écoulement hydrophobe comportant au moins une partie de surface hydrophobe qui est moins hydrophile qu'une partie de surface de canal d'écoulement dans une section de canal d'écoulement hydrophile adjacente à ladite section de canal d'écoulement hydrophobe, et dans laquelle, à l'étape de liaison, la base et le couvercle de cartouche sont liés dans au moins une première et une deuxième ligne de liaison s'étendant respectivement sur un premier et un deuxième côté du creux en forme de canal, de sorte que l'au moins une partie de surface hydrophobe soit adjacente à au moins une des lignes de liaison, ladite au moins une partie de surface hydrophobe s'étendant de préférence à partir d'au moins une ligne de liaison vers au moins le bord le plus proche du creux en forme de canal.

46. Méthode selon la revendication 45, dans laquelle ladite étape de traitement comprend un traitement d'activation d'au moins soit la base de cartouche soit le couvercle pour augmenter sa tension interfaciale, l'au moins une partie de surface hydrophobe étant masquée.

47. Méthode selon la revendication 45, dans laquelle ladite étape de traitement comprend un traitement d'activation d'au moins soit la base de cartouche, soit le couvercle pour augmenter sa tension interfaciale en traitant par laser l'au moins une partie de surface hydrophobe.

48. Méthode selon la revendication 45, dans laquelle ladite étape de traitement comprend un traitement d'activation d'au moins soit la base de cartouche, soit le couvercle pour augmenter sa tension interfaciale, en appliquant une couche d'un matériau présentant une tension interfaciale inférieure sur la surface ayant subi le traitement d'activation, et en traitant par laser la surface ayant subi le traitement d'activation qui entoure l'au moins une partie de surface hydrophobe.

49. Méthode selon l'une quelconque des revendications 46 à 48, dans laquelle le traitement d'activation comprend un traitement d'activation de la surface d'au moins un creux en forme de canal, de préférence le creux en forme de canal de la base de cartouche.

50. Méthode selon l'une quelconque des revendications 37 à 49, dans laquelle la base de cartouche est pourvue d'au moins une échancrure de rupture d'écoulement adjacent au creux en forme de canal et/ou le couvercle est pourvu d'une échancrure de rupture d'écoulement adjacent à la partie du couvercle destinée à se trouver au-dessus du creux en forme de canal, et dans laquelle la base de cartouche et le couvercle sont liés dans au moins une première et une deuxième ligne de liaison s'étendant respectivement sur un premier et un deuxième côté du creux en forme de canal de sorte que l'échancrure de rupture d'écoulement soit adjacente à la liaison ou s'étende jusqu'à l'intérieur de celle-ci.

51. Méthode selon la revendication 50, dans laquelle la base de cartouche et le couvercle sont liés de sorte qu'un matériau de liaison, tel qu'une colle ou un polymère de soudage s'écoule à l'intérieur d'une section de rupture d'écoulement fournie par l'espace entre la base de cartouche et le couvercle au niveau de l'échancrure de rupture d'écoulement.

52. Méthode selon la revendication 51, dans laquelle le matériau de liaison a pénétré dans le canal d'écoulement.

EP 1 827 693 B1

Fig. 1

33

Fig. 2

**Fig. 3a**

**Fig. 3b**

22a   B21   24

25

21

## Fig. 4a

24

27

23

21

22

## Fig. 4b

**34**

**37**

**33**

**31**

**32**

## Fig. 5b

**35**

**37**

**33**

**31**

**32**

## Fig. 5c

**31**

**36**

**33**

B

C

B'

C'

**34** **35**

## Fig. 5a

EP 1 827 693 B1

Fig. 6

38

54

52

53

51

55a

Fig. 7a

54

52

53

51

55b

Fig. 7b

54

52

53

51

55c

Fig. 7c

54

52

53

51

55d

Fig. 7d

Fig. 8

Fig. 9

85a        85b        85c        82

83

85d        85e        85f        84

81

Fig. 10

94

93

**Fig. 11a**

B ↑                                                        B' ↑

92        95

**Fig. 11b**

92        97

93

91

104

**103**

B ↑                                                        B' ↑

102      105        106

**Fig. 12a**

102      107      103

**101**

**Fig. 12b**

**REFERENCES CITED IN THE DESCRIPTION**

**Patent documents cited in the description**

- US 5300779 A
- US 5144139 A
- EP 831679 A
- WO 0044207 A
- US 20020175151 A
- US 4618476 A
- US 6451264 B